(19) Europäisches Patentamt / European Patent Office / Office européen des brevets

(11) **EP 2 659 031 B1**

(12) **EUROPEAN PATENT SPECIFICATION**

(45) Date of publication and mention
of the grant of the patent:
**18.02.2015 Bulletin 2015/08**

(21) Application number: **11819012.3**

(22) Date of filing: **28.12.2011**

(51) Int Cl.:
***C30B 15/26*** *(2006.01)*

(86) International application number:
**PCT/IB2011/055994**

(87) International publication number:
**WO 2012/090172 (05.07.2012 Gazette 2012/27)**

(54) **MEASURING A CRYSTAL GROWTH FEATURE USING MULTIPLE CAMERAS**

MESSUNG EINES KRISTALLZÜCHTUNGSMERKMALS MIT MEHREREN KAMERAS

MESURE D'UNE CARACTÉRISTIQUE DE CROISSANCE CRISTALLINE À L'AIDE DE MULTIPLES CAMÉRAS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.12.2010 US 201061428339 P**

(43) Date of publication of application:
**06.11.2013 Bulletin 2013/45**

(73) Proprietor: **MEMC Electronic Materials, Inc.
St. Peters, MO 63376 (US)**

(72) Inventors:
• **KIMBEL, Steven L.
St. Peters, Missouri 63376 (US)**
• **FUERHOFF, Robert H.
St. Peters, Missouri 63376 (US)**

(74) Representative: **Maiwald Patentanwalts GmbH
Elisenhof
Elisenstrasse 3
80335 München (DE)**

(56) References cited:
**DE-A1- 19 738 438      US-B1- 6 175 652**

• **Steven L. Kimbel ET AL: "Shape estimation for on-line diameter calibration in Czochralski silicon crystal growth", Proceedings of SPIE Vol. 4188 (2001) Process Imaging for Automatic Control, 1 January 2001 (2001-01-01), pages 45-56, XP55021176, Retrieved from the Internet: URL:http://scitation.aip.org/getpdf/servle t/ GetPDFServlet?filetype=pdf&id=PSISDG0041 88000001000045000001&idtype=cvips&doi=10.1 117/12.417181&prog=normal [retrieved on 2012-03-07]**
• **Hurle: "ANALYT(CAL REPRESENTATION OF THE SHAPE OF THE MENISCUS IN CZOCHRALSKI GROWTH", Journal of Crystal Growth vol. 63, 1 January 1983 (1983-01-01), pages 13-17, XP55021155, Retrieved from the Internet: URL:http://pdn.sciencedirect.com/ science?_ ob=MiamiImageURL&_cid=271622&_ user=987766& _pii=0022024883904219&_ check=y&_origin=bro wse&_zone=rslt_list_ item&_coverDate=1983-0 9-30&wchp=dGLbVlk- zSkWb&md5=8b58be5f3deafa 2538a3336654127938/1-s2.0-0022024883904219 -main.pdf [retrieved on 2012-03-07] cited in the application**

# EP 2 659 031 B1

**Description**

BACKGROUND

Crystal pulling machines employing the Czochralski process produce a majority of the monocrystalline silicon used to make silicon wafers for the microelectronics industry. As known in the art, the Czochralski process involves melting high-purity polycrystalline silicon in a quartz crucible located in a specifically designed furnace to form a silicon melt. The lower end of a pull wire hanging from a crystal lifting mechanism suspends a relatively small seed crystal above the crucible. The crystal lifting mechanism lowers the seed crystal into contact with the molten silicon in the crucible. When the seed begins to melt, the mechanism slowly withdraws it from the silicon melt. As the seed is slowly withdrawn, it draws growing silicon from the melt.

As crystal growth is initiated, the thermal shock of contacting the seed with the melt may cause dislocations in the crystal. Unless eliminated in the neck region between the seed crystal and the main body of the crystal, the dislocations propagate throughout the growing crystal and can multiply, resulting in a loss of single crystal structure. The known methods of eliminating dislocations within single crystal silicon involve growing a neck having a small diameter at a relatively high crystal pull rate to completely eliminate dislocations before growing the body of the crystal. After dislocations are eliminated in the neck, its diameter is increased until the desired diameter of the main crystal body is reached. If the neck, which is the weakest part of the crystal, has too small of a diameter, it can fracture during crystal growth causing the body of the crystal to drop into the crucible. The impact of the crystal ingot and splashing molten silicon may cause damage to the crystal growing apparatus as well as present a safety hazard.

As is known in the art, the Czochralski process is controlled, in part, as a function of the diameter of the crystal ingot being grown. Several technologies are known for providing crystal diameter measurements, including methods of estimating a diameter of a bright ring. The bright ring is a characteristic of the reflection of the crucible wall in the meniscus which is formed at the interface between the silicon melt and the crystal, also referred to as a solid-liquid interface or a melt-solid interface. Conventional bright ring and meniscus sensors employ optical pyrometers, photocells, rotating mirrors with photocells, light sources with photocells, line-scan cameras, and/or two-dimensional array cameras to determine a diameter of a crystal during the crystal growth process. Crystal measuring apparatus typically include a single camera, such as a monochrome charge coupled device (CCD) camera, mounted in a viewport of the crystal growing chamber at an angle with respect to the axis of the growing crystal. The camera generates a video image of the crystal including an image of the meniscus at the melt-solid interface. Examples of such camera controlled systems are to be found in DE 19738438 and in the article by Kimbel et al. "Shape estimation for on-line diameter calibration in Czochralski silicon crystal growth" Proc. SPIE Vol 4188 (2001) pages 4556.

Typically, such existing camera systems may rely on use of a dipstick to determine an initial melt elevation with respect to a dipstick support, and an approximation of a subsequent melt elevation based on mass balance. Furthermore, laser reflection methods may be used where laser light is sourced and is reflected from the liquid silicon surface. The elevation of the detected reflection is determined by the angle of the melt surface at the laser incidence point and the elevation of the liquid. With the existing systems, accuracy of the melt elevation determination is limited. For example, dipstick etching caused by contact with the reactive silicon melt may change the melt elevation measurement and thereby negatively affect the quality of the crystal. Increasing the accuracy of a melt elevation determination would facilitate greater control over the crystal growth process and therefore, greater control over the quality of the silicon ingot.

BRIEF DESCRIPTION

In one aspect, a method for three-dimensional measurement of a growing crystal being pulled from a crucible is provided. A first camera captures a first image of the growing crystal on a first image plane and a second camera captures a second image of the growing crystal on a second image plane. The method includes generating a mathematical model of a crystal during crystal growth, the mathematical model including a plurality of model sample points. The method also includes detecting at least one crystal growth feature within the first image and the second image and determining a first error value by comparing the mathematical model to the at least one crystal feature within the first image and a second error value by comparing the mathematical model to the at least one crystal feature within the second image. Furthermore, an estimated 3-D metrology value associated with the at least one crystal growth feature is generated by adjusting the mathematical model to minimize the determined first error value and the determined second error value.

In another aspect, a system for measuring a crystal during crystal growth is provided. The system includes a first camera configured to capture a first image of the crystal during growth on a first image plane and a second camera configured to capture a second image of the crystal during growth on a second image plane. The system also includes a processing device communicatively coupled to the first camera and the second camera. The system is programmed to generate a mathematical model of a crystal during crystal growth. The mathematical model includes a plurality of model sample points including a first model sample point. The system is further programmed to detect at least one crystal growth feature within the first image and the second image and to determine a first error value by comparing the mathematical model to the crystal growth feature in the first image and a second error value by comparing the mathematical model to the crystal growth feature in the second image. The system is also programmed to generate, from the mathematical model and based on the determined first error value and the determined second error value, an estimated metrology value associated with the at least one crystal growth feature.

BRIEF DESCRIPTION OF THE DRAWINGS

Figure 1 is a block diagram of an exemplary crystal growing apparatus and system for controlling the crystal growing apparatus.

Figure 2 is an expanded block diagram of the exemplary control system shown in Figure 1.

Figure 3 is a fragmentary view of a silicon crystal being pulled from a melt.

Figure 4 is a perspective view of an exemplary dual-camera assembly that may be used with the control system shown in Figure 2.

Figure 5 is a perspective view of an exemplary calibration system for calibrating the dual-camera assembly shown in Figure 4.

Figure 6 is an illustration of a mathematical model of a portion of the control system shown in Figure 2.

Figure 7 is an exemplary image captured by a first camera of the control system shown in Figure 2.

Figure 8 is an exemplary image captured by a second camera of the control system shown in Figure 2.

Figure 9 is a flow chart of an exemplary method for three-dimensional measurement of a growing crystal.

Figure 10 is a flow chart of exemplary operations to determine a first camera error and a second camera error.

DETAILED DESCRIPTION

Embodiments of the disclosure facilitate determining three-dimensional measurements of features of a crystal and of hotzone components as they change from ingot-to-ingot or during growth of an individual ingot. After generating a calibration dataset for a first camera and a second camera, errors in an estimated crystal and/or hotzone dimension are estimated using images from the first camera and the second camera, in combination with a sensitivity matrix generated from the calibration dataset. For example, a melt elevation, a diameter of the crystal, and/or an elevation of a hotzone feature may be determined. Operating parameters of a crystal growing apparatus may be adjusted based on the estimated dimensions.

Technical effects of the methods, systems, and computer-readable media described herein include at least one of: (a) generating a mathematical model of a crystal during crystal growth, the mathematical model including a plurality of model sample points; (b) detecting at least one crystal growth feature within the first image and the second image; (c) determining a first error value and a second error value by comparing the mathematical model to the at least one crystal growth feature; and (d) generating an estimated 3-D metrology value associated with the at least one crystal growth feature by adjusting the mathematical model to minimize the determined first error value and the determined second error value.

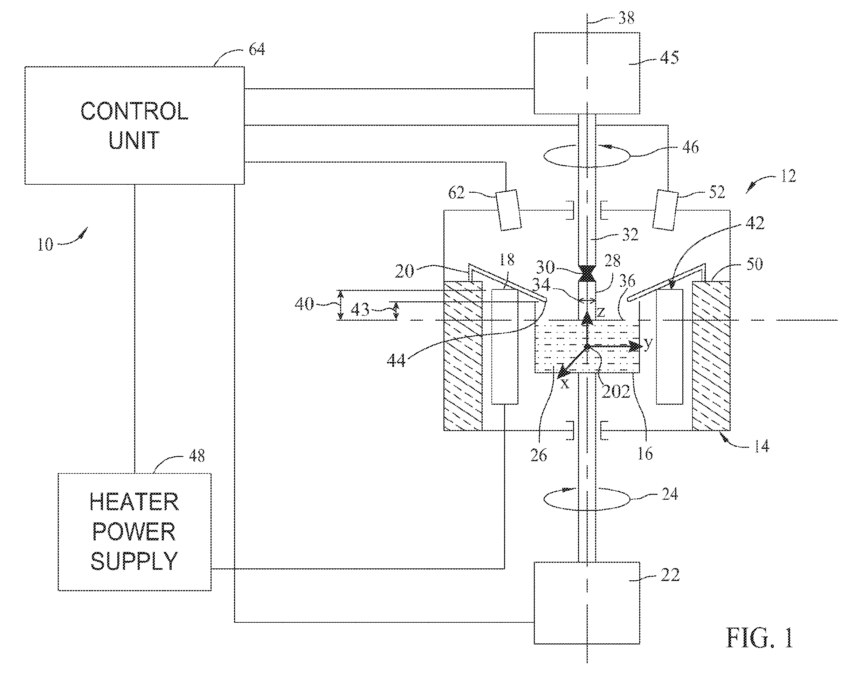

Figure 1 is a block diagram of an exemplary control system 10 for use with a Czochralski crystal growing apparatus 12. In the exemplary embodiment, crystal growing apparatus 12 includes a vacuum chamber 14 enclosing a crucible 16 which is surrounded by a resistance heater 18 or other heating means. Crystal growing apparatus 12 may also include a reflector 20. Generally, a crucible drive unit 22 rotates crucible 16 in a clockwise direction, as indicated by arrow 24, and raises and lowers crucible 16 as desired during the growth process. Crucible 16 contains a silicon melt 26 from which a single crystal 28 is pulled, starting with a seed crystal 30 attached to a pull shaft or cable 32, and having a diameter 34. Single crystal 28 is also referred to herein as a crystal ingot. Silicon melt 26 has a melt surface 36, which during crystal growth may also be referred to as a melt-gas interface, and crucible 16 and crystal ingot 28 have a nearly common vertical axis of symmetry 38. A melt-level elevation 40 is defined as a distance between melt-gas interface 36 and an arbitrary but fixed reference, for example, but not limited to, a top 42 of heater 18. A reflector to melt gap dimension 43 is defined as a distance between melt-gas interface 36 and a bottom 44 of reflector 20. Dimension 43 is also referred to herein as a melt gap dimension, or a melt gap.

According to the Czochralski crystal growth process, a crystal drive unit 45 typically rotates cable 32 in a direction opposite to the direction that crucible drive unit 22 rotates crucible 16, i.e., crystal drive unit 45 rotates cable 32 in a second direction, indicated by arrow 46, opposite to the direction crucible drive unit 22 rotates crucible 16. Crystal drive unit 45 also raises and lowers crystal ingot 28 as desired during the growth process. A heater power supply 48 energizes resistance heater 18 and insulation 50 lines an inner wall of vacuum chamber 14. A vacuum pump (not shown) may be included to remove gas from within vacuum chamber 14 which is replaced by an inert atmosphere of, for example, argon gas fed into vacuum chamber 14. A chamber cooling jacket (not shown) fed with cooling water may surround crystal ingot 28. A temperature sensor 52, for example, but not limited to, a photo cell, may measure a melt surface temperature for thermal stabilization of silicon melt 26.

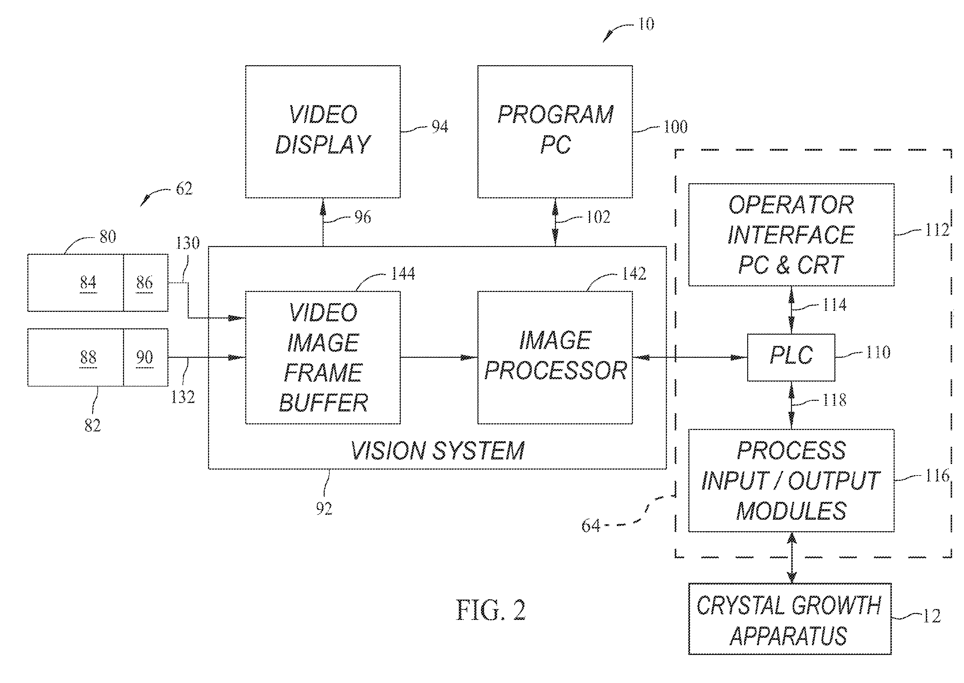

In the exemplary embodiment of Figure 1, control system 10 includes a plurality of cameras 62 coupled to a control unit 64. The plurality of cameras 62, in combination with control unit 64, are configured to determine a dimension of at least one crystal growth parameter (i.e., feature). The crystal growth feature may include a crystal feature of crystal ingot 28 during growth of crystal ingot 28, for example, but not limited to, a diameter of crystal ingot 28 and melt level elevation 40. The crystal growth feature may also include a hotzone feature, for example, but not limited to, melt gap 43, a tilt of reflector 20, and a rotational position of a reflector edge within a reflector notch. Control unit 64 processes signals from temperature sensor 52 as well as from the plurality of cameras 62. Control unit 64 may also receive signals from any other sensor that facilitates controlling crystal growth as described herein. Control unit 64 may include a programmed digital or digital plus analog computer, for example, a processing device 110 (shown in Figure 2), for use in controlling, among other things, crucible drive unit 22, crystal drive unit 45, and heater power supply 48.

Referring further to Figure 1, according to a typical silicon single crystal growth process, a quantity of polycrystalline silicon is charged to crucible 16. Heater power supply 48 provides electric current through heater 18 to melt the charge. Crystal drive unit 45 lowers seed crystal 30 via cable 32 into contact with the molten silicon of silicon melt 26 contained by crucible 16. When seed crystal 30 begins to melt, crystal drive unit 45 slowly withdraws, or pulls, seed crystal 30 from silicon melt 26. Seed crystal 30 draws silicon from silicon melt 26 to produce crystal ingot 28 as it is pulled from silicon melt 26. Before seed crystal 30 contacts silicon melt 26, it may first be necessary to lower seed crystal 30 nearly in contact with silicon melt 26 for preheating seed crystal 30.

Crystal drive unit 45 rotates crystal ingot 28 at a reference rate as it is pulled from silicon melt 26. Crucible drive unit 22 similarly rotates crucible 16 at a second reference rate, but usually in the opposite direction relative to crystal ingot 28. Control unit 64 initially controls the withdrawal rate (i.e., pull rate) and a power supplied to heater 18 by heater power supply 48 to cause a neck down of crystal ingot 28. Control unit 64 may then adjust these parameters to cause diameter 34 of crystal ingot 28 to increase in a cone-shaped manner until a desired crystal diameter 34 is reached. Once crystal ingot 28 reaches the desired crystal diameter 34, control unit 64 controls the pull rate and/or heating to maintain a substantially constant diameter as measured by system 10 until the process approaches its end. At that point, control unit 64 causes the pull rate and heating to increase so that the diameter decreases to form a tapered portion at the end of crystal ingot 28.

As described above, accurate and reliable control is desired during the crystal growth process, particularly in the neck portion of crystal ingot 28. Control unit 64 may be configured to cause a substantially constant neck diameter to be maintained so that the neck diameter remains within, for example, ten percent of the desired diameter. As is known in the art, the top portion of the neck adjacent seed crystal 30 may contain dislocations (not shown) first introduced by the thermal shock associated with bringing the dislocation-free seed crystal 30 into contact with silicon melt 26. Excessive fluctuations in neck diameter may also cause dislocations to multiply. In the embodiment of Figure 1, control system 10 is configured to control crystal and crucible rotation rates as a function of, for example, the crystal length and/or the crystal diameter.

Figure 2 is a block diagram of an exemplary embodiment of control system 10 (shown in Figure 1). In the exemplary embodiment of Figure 2, control system 10 includes plurality of cameras 62 and control unit 64. In the exemplary embodiment, the plurality of cameras 62 includes a first camera 80 and a second camera 82. First camera 80 includes at least one image sensor 84 and is coupled to a lens 86 configured to focus light onto image sensor 84. Similarly, second camera 82 includes at least one image sensor 88 and is coupled to a lens 90 configured to focus light onto image sensor 88. In the exemplary embodiment of Figure 2, control system 10 also includes a vision system 92 coupled between control unit 64 and the plurality of cameras 62. In an alternative embodiment, vision system 92 may be included within control unit 64. In the exemplary embodiment, the plurality of cameras 62 are mounted at a viewport (e.g., a window) of chamber 14 (shown in Figure 1) at an angle of approximately 15° or 25° with respect to vertical axis 38 (shown in Figure 1) and are aimed generally at the intersection of vertical axis 38 and silicon melt 26 (shown in Figure 1) at melt-gas interface 36 (shown in Figure 1). Melt-gas interface 36 may be identified during the crystal growth process by locating a bright ring within an image of the growing crystal, where the bright ring is a reflection of at least one hotzone component on the reflective silicon melt 26.

In the exemplary embodiment of Figure 2, vision system 92 also communicates with a video display 94 via line 96 (e.g., video graphics array (VGA) or digital visual interface (DVI) video cable) and with a personal computer 100 via line 102 (e.g., RS-232 cable). Video display 94 displays a video image generated by at least one of first camera 80 and second camera 82 and personal computer 100 is used to program vision system 92.

Control unit 64 includes a processing device 110. More specifically, vision system 92 is coupled to processing device 110. Processing device 110, also referred to herein as a processor, may include, but is not limited to, central processing units, microprocessors, microcontrollers, programmable logic controllers (PLC), reduced instruction set circuits (RISC), application specific integrated circuits (ASIC), logic circuits, and any other circuit or processor capable of executing the functions described herein. Processing device 110 communicates with an operator interface computer 112 via a line 114 (e.g., RS-232 cable) and with one or more process input/output modules 116 via a line 118 (e.g., RS-485 cable). Operator interface computer 112 permits an operator of crystal growing apparatus 12 to input a set of desired parameters for the particular crystal being grown. Process input/output module 116 provides a path to and from crystal growing apparatus 12 for controlling the growth process. As an example, processing device 110 receives information regarding melt temperature from temperature sensor 52 (shown in Figure 1) and outputs a control signal to heater power supply 48 (shown in Figure 1) via process input/output module 116 for controlling the melt temperature and thereby controlling the growth process. Furthermore, processing device 110 may receive data from the plurality of cameras 62, determine a crystal diameter from the data, through vision system analysis by vision system 92, and output a control signal to crystal drive unit 45 (shown in Figure 1) through process input/output modules 116, for controlling a rate at which seed crystal 30 is withdrawn from silicon melt 26, thereby controlling the growth process.

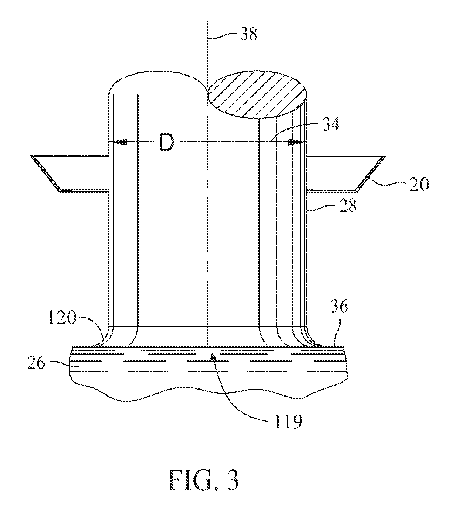

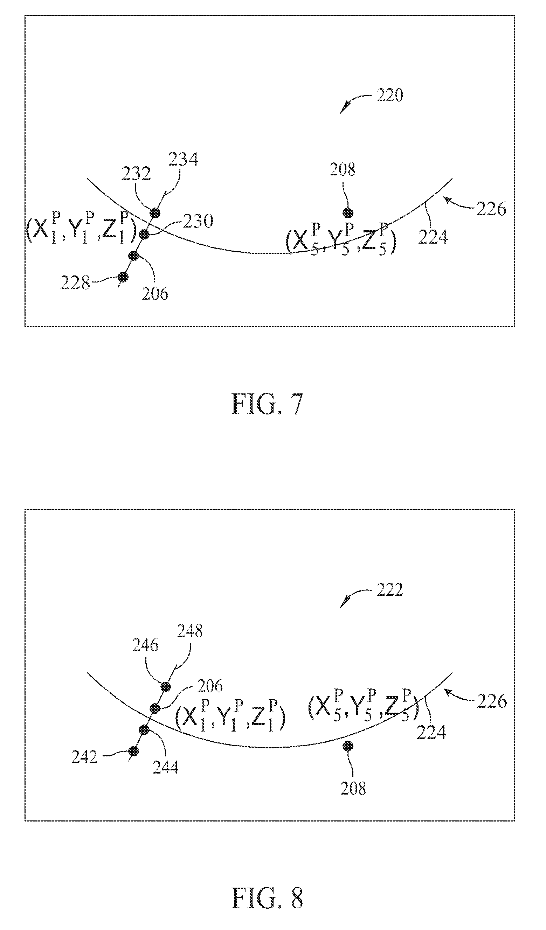

Figure 3 is a fragmentary view of crystal ingot 28 being pulled from silicon melt 26. Crystal ingot 28 constitutes a generally cylindrical body of crystalline silicon having vertical axis 38 and diameter 34. An as-grown crystal, such as crystal ingot 28, may not have a uniform diameter, although it is generally cylindrical. For this reason, diameter 34 may vary slightly at different axial positions along vertical axis 38. Furthermore, diameter 34 will vary in different phases of crystal growth, for example, seed, neck, crown, shoulder, body, and end cone. In the exemplary embodiment, first camera 80 and second camera 82 each generate a video image of a growing crystal whose lower terminus is a melt-solid interface 119, which is adjacent to and connected by a curved liquid meniscus 120 to melt-gas interface 36. Meniscus 120 is formed by the lifting of crystal ingot 28, as crystal drive unit 45 pulls crystal ingot 28 from silicon melt 26. Meniscus 120 is identified within the video images as a bright ring-shaped reflection. The bright ring-shaped reflection is referred to herein as a "bright ring" (shown in Figures 7 and 8). The bright ring is a reflection of a hotter hotzone component, for example, a wall of crucible 16, on reflective meniscus 120. Identifying the bright ring in an image facilitates determining a location of melt-solid interface 119 through the physical shape of meniscus 120.

First camera 80 and second camera 82 communicate the video images via at least one line (e.g., RS-170 video cable or Universal Serial Bus (USB) cable), for example, first line 130 and second line 132, respectively, to vision system 92. In the exemplary embodiment, vision system 92 includes an image processor 142.

In the exemplary embodiment of Figure 2, first camera 80 and second camera 82 are discrete digital cameras. First camera 80 may be coupled to vision system 92 using serial communication, for example, but not limited to, USB communication. Alternatively, first camera 80 may be coupled to vision system 92 using parallel communication. First camera 80, second camera 82, and associated lenses 86 and 90, may be of the same design and/or model number, however, first camera 80 and second camera 82 do not have to include the same technology in order to generate repeatable results so long as independent camera calibrations are performed for each camera. In an alternative embodiment, first camera 80 and/or second camera 82 are monochrome charge coupled device (CCD) cameras, such as a Sony XC-75 CCD video camera having a resolution of 768x494 pixels with an analog output, for example, but not limited to, RS-170. In the alternative embodiment, vision system 92 includes a frame grabber card 144 coupled between the RS-170 cameras and image processor 142.

Although non-discrete digital camera types, such as RS-170 cameras with frame grabber card 144 can be used, they are less desirable due to video and imaging noise, as well as data transmission noise. For example, low analog signal levels transmitted to frame grabber card 144 may result in elevated video noise in an electrically noisy environment, such as the environment surrounding crystal growing apparatus 12. If the camera is an interlaced camera, rather than a progressive scan camera, then brightness variations are possible in alternating video lines, causing an edge detection noise. Also, since frame grabber card 144 generates horizontal line digitization with timing which may not exactly match the read-out timing of the video data from, for example, first camera 80, frame grabber digitization of an analog RS-170 video signal may generate bias, drift, and/or noise in the dimensional edge detection due to temporal compression/expansion in the line scan direction. Depending on the measurement direction, the bias, drift, and/or noise may have an effect of degrading the measurement accuracy of the desired crystal growth parameter. A serial (e.g. USB) or parallel digital camera transmits higher level digital signals which are not as likely to be affected by ambient electrical noise.

In addition, a coordinate-wise addressing of individual pixels in a digital camera prevents edge detection variation due to digitization timing differences and interlace noise, each of which may be observed if using an RS-170 camera. Furthermore, imaging of a growing crystal includes some higher speed movement, for example, melt vibrations, crystal swinging, and in particular, crystal rotation. In addition to normal facet appearance, which may appear as small raised lines on a surface of crystal ingot 28, some crystal ingots may also have a threaded, or corkscrew appearance, large flats, or other surface distortions which increase the difficulty of cylindrical model fitting. Accurate three-dimensional fitting of a mathematical model shape in the presence of high speed movements is further aggravated by a difference in capture timing of camera images from multiple cameras. A multiple RS-170 camera system, where each camera signal is routed through the same frame grabber, for example, frame grabber card 144, may have a difference in timing of, for example, 1/30 or 1/15 of a second between a camera signal from a first camera and a camera signal from a second camera. At a 15 RPM crystal rotation, a timing delay of 1/30 or 1/15 of a second would represent 3 to 6 degrees of crystal rotation. Thus non-simultaneous image capture of crystal distortions in a rapidly moving scene, for example when a crystal with wide flats is rapidly rotating, can increase measurement noise due to the positional difference captured by the cameras. The fitting error due to fast-moving scene changes may be corrected by obtaining very nearly simultaneous image capture by using an external trigger signal to capture images simultaneously on serial or parallel digital cameras. Fast exposure times (e.g. 1/250 second or 1/1000 second) may be used, which provide nearly stop-action images, because of the high light levels present in crystal growing apparatus 12. Of further consideration in a manufacturing environment is the generally lower cost of serial digital cameras compared with CCD cameras plus a frame grabber card/board or multiple frame grabber cards/boards.

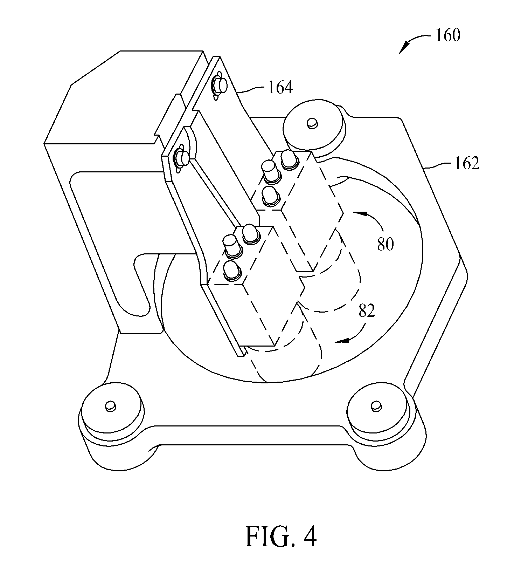

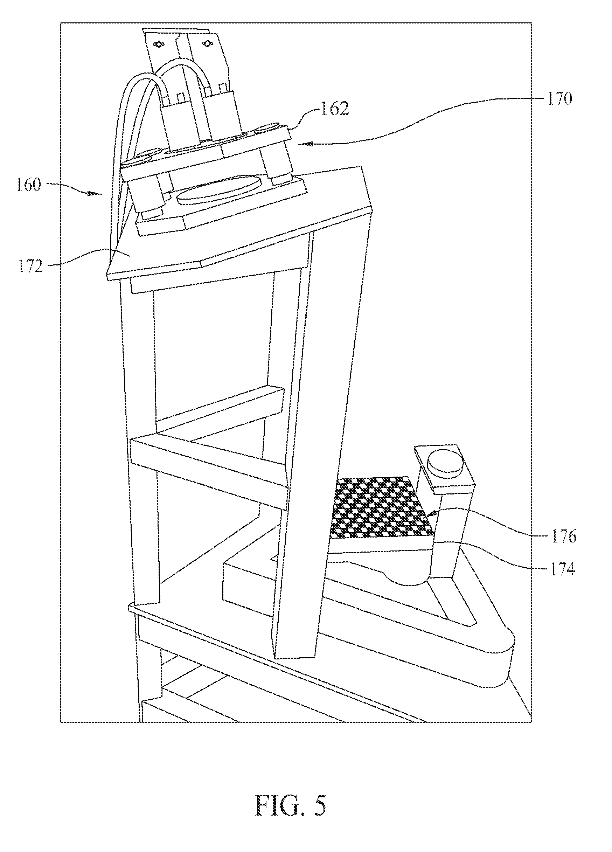

Figure 4 is a perspective view of an exemplary dual-camera assembly 160 for use with control system 10 (shown in Figures 1 and 2). In the exemplary embodiment of Figure 4, dual-camera assembly 160 includes a camera mounting system 162 and two cameras, for example, first camera 80 and second camera 82. Camera mounting system 162 physically couples first camera 80 and second camera 82 to crystal growing apparatus 12 (shown in Figure 1) or to a camera calibration system 170 (shown in Figure 5). In the exemplary embodiment of Figure 4, camera mounting system 162 includes a common plate 164, onto which first camera 80 and second camera 82 are physically coupled. Plate 164 may be ceramic, for example, a moderate temperature glass-mica ceramic, or any other suitable material that facilitates stable coupling of first camera 80 and second camera 82 to each other and/or to crystal growing apparatus 12 in a moderate temperature environment. First camera 80 and second camera 82 are coupled to plate 164 by fasteners, for example, four mounting screws each, and plate 164 is leveled with respect to crystal growing apparatus 12 and to camera calibration system 170.

More specifically, camera mounting system 162 couples first camera 80 and second camera 82 to calibration system 170, and subsequent to calibration, also couples first camera 80 and second camera 82 to crystal growing apparatus 12 without changing a position of first camera 80 relative to second camera 82 and with accurate replication of world rotations. Furthermore, first camera 80 and second camera 82 are positioned by camera mounting system 162 relative to calibration system 170 the same as first camera 80 and second camera 82 are positioned relative to crystal growing apparatus 12. Moreover, to prevent camera focus from changing during or after the calibration procedure, camera lens focus rings may be secured to the lens body after setting the focus to the approximate working object distance. For example, camera lens focus rings may be glued and/or screwed to the lens body after setting the focus to the approximate working object distance. Since growth of crystals at high temperature generally provides for a bright environment relative to camera design specifications, the camera f-stop is nearly closed in operation, providing a large operating depth of field. The camera f-stop may differ between calibration system 170 and crystal growing apparatus 12, for example, due to calibration system 170 providing lower illumination than crystal growing apparatus 12. If cameras 80 and 82 are not operated in saturation when positioned within calibration system 170 or crystal growing apparatus 12, changing the camera f-stop does not negatively affect calibration and/or measurement accuracy.

Figure 5 is a perspective view of an exemplary embodiment of a calibration system 170. In the exemplary embodiment of Figure 5, calibration system 170 includes a mounting surface 172 configured to securely couple camera mounting system 162 to calibration system 170. Calibration system 170 also includes a target surface 174. A calibration target 176 is positioned on, and/or secured to, target surface 174. In the exemplary embodiment of Figure 5, calibration target 176 is plastic and imprinted with a calibration grid having squares of known dimensions. Calibration target 176 may be secured to target surface 174 using glue, being weighed down by glass, or in any other manner that facilitates maintaining calibration target 176 flat against target surface 174 and fixed with respect to target surface 174. Although described as plastic, the calibration grid may be imprinted on paper, etched into metal, or formed in any other manner that allows calibration system 170 to function as described herein. However, effects of dimensional changes caused by moisture, which would have the greatest effect on paper, may negatively affect the accuracy of calibration target 176.

Calibration system 170 maintains camera mounting system 162 and target surface 174 in a fixed relative position. This position matches a relative position of camera mounting system 162 with respect to melt-gas interface 36 (shown in Figure 1) when camera mounting system 162 is coupled to crystal growing apparatus 12 (shown in Figure 1).

Although described as a separate fixture from crystal growing apparatus 12 (shown in Figure 1), calibration of first camera 80 and second camera 82 may be implemented using a calibration system included within crystal growing apparatus 12. In the exemplary embodiment of Figure 5, first camera 80 and second camera 82 are calibrated using dedicated camera calibration system 170. However, other methods of calibration do not fundamentally change the nature of the systems and methods described here, but rather, only change an operational risk. Calibration of first camera 80 and second camera 82 is of particular importance to the methods and systems described herein because de-calibration (e.g., due to lens replacement, camera failure and replacement, etc.) may occur at any time, potentially causing highly inaccurate camera measurements within a crystal run series since a cold furnace is not available on which to perform recalibration.

Camera calibration is the generation of a set of camera plus lens intrinsic and extrinsic parameters. Knowing the generally very precise spacing of camera image pixels and using a series of images of precise targets (e.g., calibration target 176) at various translations and/or orientations, camera calibration parameters may be generated for a particular lens and camera combination that represent estimates of, for example, actual lens focal length, lens distortions, orientations of the camera relative to the targets, and projection matrix coefficients. For example, while first camera 80 and lens 86 are coupled to camera mounting system 162, a first dataset of camera calibration parameters is generated for the combination of first camera 80 and lens 86 using calibration system 170. Furthermore, a second dataset of camera calibration parameters is generated for the combination of second camera 82 and lens 90 using calibration system 170. With this information, in addition to accurate dimensional information of the target feature spacing and relative elevations, an image of mathematical model coordinates may be accurately mathematically projected onto a camera image having known orientations. Published examples of camera calibration mathematics are available from, publications including Heikkilä and Silvén, A Four-step Camera Calibration Procedure with Implicit Image Correction, IEEE Computer Society Conference on Computer Vision and Pattern Recognition (CVPR97), San Juan, Puerto Rico, 12997, pp 1006-1112, and R.Y. Tsai, A Versatile Camera Calibration Technique for High-Accuracy 3-D Machine Vision Metrology Using Off-the-Shelf TV Cameras and Lenses, IEEE Journal of Robotics and Automation, RA-3, No. 4, August 1987, pp. 323-344. A calibration data file that includes camera calibration parameters may be generated for each camera/lens combination used, or individual camera calibration data files may be concatenated into a single file. This file or these files are then transported with dual-camera assembly 160 to crystal growing apparatus 12.

In the exemplary embodiment of Figure 5, camera assembly calibration is performed by moving target surface 174 and calibration target 176, which is a leveled and precisely measured target, vertically through multiple elevations, stopping at each elevation to capture images using first camera 80 and second camera 82. As described above, calibration target 176 may include a grid or circular target points. The center of the target points or intersections of the imaged target grid are located within each image to within sub-pixel resolution using analytical software, and these intersections, plus the precise physical location of each intersection coordinate relative to an assumed world zero location (e.g., a center location of the target on the first elevation), are analyzed by camera calibration software to determine intrinsic and extrinsic camera plus lens calibration parameters for each camera/lens combination.

Dual-camera assembly 160 is then transported to crystal growing apparatus 12 with the calibration data file that includes the camera calibration parameters and is mounted to crystal growing apparatus 12 at a viewport, for example, a single crystal puller window (not shown). Multiple windows may be used, but would require a larger camera mounting system 162 (shown in Figure 4) to span the multiple windows. Dual-camera assembly 160 is then precisely re-leveled to provide an accurate rotational reference that matches the calibration fixture rotational reference. On-line fitting software is then used to analyze the elevation and diameter of the growing silicon crystal reflective meniscus 120 (shown in Figure 3), as located by identification of an edge 224 of a bright ring 226 within images 220 and 222 (shown in Figures 7 and 8). Features of hotzone components, for example, a feature of reflector 20 (shown in Figure 1) may also be analyzed in order to provide relative dimensional information such as reflector elevation estimates. The melt level elevation 40 and reflector elevation estimates may in turn used to estimate melt gap 43 and to adjust operating parameters used to control operation of crystal growing apparatus 12 for increased uniform ingot quality and/or improved ingot dimensional control.

In order to transport the calibration parameters accurately from camera calibration system 170 to crystal growing apparatus 12, a reference orientation to which cameras 80 and 82 are aligned is required on both calibration system 170 and crystal growing apparatus 12. Since a gravity vector is available at both calibration system 170 and crystal growing apparatus 12, precision leveling of a surface firmly attached to cameras 80 and 82 on both calibration system 170 and on crystal growing apparatus 12 may be used to duplicate an orientation of cameras 80 and 82 on crystal growing apparatus 12 which were present on calibration system 170. Since by gravity silicon melt 26 maintains on average a level surface with crystal growth generally orthogonal to that surface, calibration target 176 may also be leveled to simulate measurement points on the melt surface. If a provision is made for accurate vertical translation of calibration target 176, images may be captured of the same target at multiple elevations, providing a set of precisely located three-dimensional image data, which is used to generate precise camera calibration parameters.

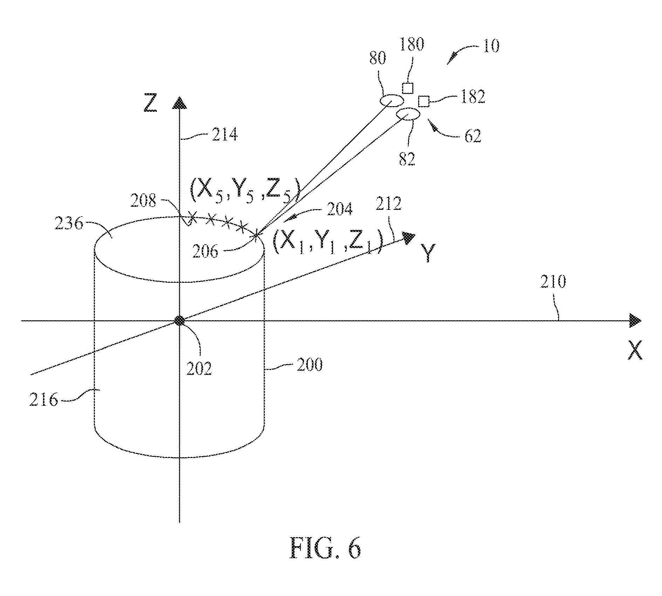

Figure 6 is an illustration of a mathematical model of a portion of control system 10 (shown in Figure 2) including plurality of cameras 62. In the exemplary embodiment of Figure 6, plurality of cameras 62 includes first camera 80 and second camera 82, positioned at the viewport of crystal growing apparatus 12 (shown in Figure 1). First camera 80 captures an image on an image plane 180 and second camera 82 captures an image on an image plane 182. Figure 7 is an exemplary image 220 captured by first camera 80 of control system 10. Figure 8 is an exemplary image 222 captured by second camera 82 of control system 10.

In the exemplary embodiment, a real-world mathematical model 200 is centered about a world zero reference point 202. Mathematical model 200 includes a plurality of model sample points 204, for example, first model sample point 206 and second model sample point 208. The plurality of sample points 204 correspond to at least one crystal growth feature, for example, but not limited to, samples along the bright ring which includes information about crystal diameter 34 (shown in Figure 1) and melt-level elevation 40 (shown in Figure 1). A three-dimensional coordinate system including an x-axis 210, a y-axis 212, and a z-axis 214 is shown, although, other coordinate systems known in the art may be used to define mathematical model 200. Mathematical model 200 is generated to generally match an expectation of crystal growth within crystal growing apparatus 12 to facilitate providing representative and repeatable measurements of crystal growth features. In the exemplary embodiment, mathematical model 200 is a cylindrical model having sides 216 expected to substantially match the radius of the bright ring over a range of elevations. Mathematical model 200 may include sensitivities of pixel projections of each of the plurality of model sample points 204 into image planes 180 and 182 when changes in the elevation along the cylinder or the diameter of the cylinder are made. A sensitivity matrix that predicts output changes with changes in the input points is often called a Jacobian matrix.

First image 220 (shown in Figure 7) of crystal ingot 28 is captured by first camera 80 (shown in Figure 6) on image plane 180 (shown in Figure 6). An edge 224 of a bright ring 226 is identified within first image 220. As described above, bright ring 226 is a reflection of a hotzone component on meniscus 120 (shown in Figure 3). Identifying edge 224 of bright ring 226 in first image 220 facilitates determining a location of melt-gas interface 36 (shown in Figure 3). Second image 222 (shown in Figure 8) of crystal ingot 28 is captured by second camera 82 (shown in Figure 6) on image plane 182 (shown in Figure 6). Edge 224 of bright ring 226 is also identified within second image 222. In the exemplary embodiment, model sample points 204 are mathematically projected onto image plane 180 and image plane 182. More specifically, model sample point 206 and model sample point 208 are projected onto first image 220. Model sample point 206 and model sample point 208 are also projected onto second image 222. At least one sampling point, for example, sampling points 228, 230, and 232, in combination with model sample point 206, form a sampling line 234, which is projected onto first image plane 180. Sampling line 234 is orthogonal to a tangent of side 216 of mathematical model 200 and to a path to a center (not shown in Figure 6) of lens 86 of first camera 80 from model sample point 206. Furthermore, at least one sampling point, for example, sampling points 242, 244, and 246, in combination with model sample point 206, form a sampling line 248, which is projected onto second image plane 182. Sampling line 248 is orthogonal to a tangent of side 216 and to a path to a center (not shown in Figure 6) of lens 90 of second camera 82 from model sample point 206.

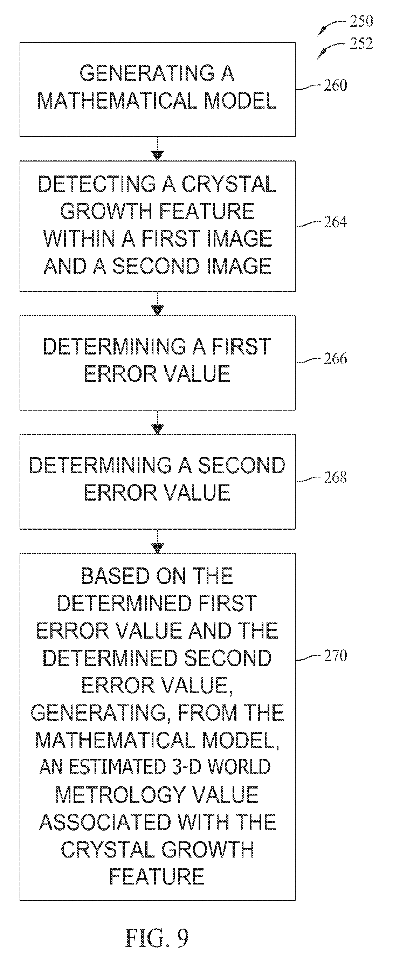

Figure 9 is a flow chart 250 of an exemplary method 252 for three-dimensional measurement of at least one crystal growth feature during crystal growth of a crystal, for example, crystal ingot 28 (shown in Figure 1) pulled from silicon melt 26 (shown in Figure 1). In an exemplary embodiment, method 252 is a computer-implemented method, for example, a computer-implemented method executed by a workstation and/or personal computer, for example, processor 110 (shown in Figure 2). In another exemplary embodiment, a computer program embodied on a computer readable medium includes at least one code segment, that when executed by a computer, performs method 252. A first camera, for example, first camera 80 (shown in Figure 2), captures a first image of crystal ingot 28 on a first image plane, for example, first image plane 180 (shown in Figure 6). A second camera, for example, second camera 82 (shown in Figure 2), captures a second image of crystal ingot 28 on a second image plane, for example, second image plane 182 (shown in Figure 6). First camera 80 and second camera 82 have been previously calibrated, which includes generating a calibration parameter dataset used in determining a plurality of feature sample points and normal directions for at least one of a plurality of model sample points described below.

Method 252 also includes generating 260 a mathematical model, for example, mathematical model 200 (shown in Figure 6) of crystal ingot 28 during crystal growth. As described above, mathematical model 200 includes a plurality of model sample points 204 (shown in Figure 6) that correspond to at least one feature of crystal ingot 28. The at least one feature may include, but is not limited to, a melt-gas interface 36 (shown in Figure 3). Included within mathematical model 200 are dimensions of the at least one feature, including, but not limited to, crystal diameter 34 (shown in Figure 1) and melt-level elevation 40 (shown in Figure 1). Generating 260 mathematical model 200 may include generating an assumed mathematical model reference, for example, model reference point 202 (shown in Figure 6), on which mathematical model 200 is centered. In the exemplary embodiment, mathematical model 200 includes an assumption of at least one of crystal diameter 34 and melt-level elevation 40 for a specific time within the crystal growing process. In the exemplary embodiment, mathematical model 200 represents the locus of bright ring elevations for a given diameter of crystal ingot 28 during crystal growth and model points 204 each have three-dimensional coordinates.

In the exemplary embodiment of Figure 9, method 252 also includes detecting 264 at least one crystal growth feature within a first image, for example, first image 220 (shown in Figure 7), and a second image, for example, second image 222 (shown in Figure 8). The crystal growth feature may include, but is not limited to, melt-gas interface 36, identified by the presence of bright ring 226 (shown in Figures 7 and 8). Method 252 also includes determining 266 a first error value by comparing mathematical model 200 to the crystal growth feature within first image 220. Method 252 also includes determining 268 a second error value by comparing mathematical model 200 to the crystal growth feature within second image 222.

Method 252 may also include generating 270 an estimated three-dimensional (3-D) metrology value associated with the at least one crystal growth feature by adjusting mathematical model 200 to minimize the determined first error value and the determined second error value. Since the camera projections cannot be collinear when using two physical cameras, information is present in the two errors about orthogonal errors in mathematical model 200. In other words, the first determined error value and the second error value are used in combination to determine an estimated 3-D metrology value associated with the at least one crystal growth feature. Generating 270 estimated 3-D metrology values associated with the at least one crystal growth feature may include, but is not limited to, generating 270 crystal diameter 34, melt-level elevation 40, and/or reflector feature elevations, from which reflector-melt elevation gap distance 43 (shown in Figure 1) may be generated. For example, generating 270 estimated 3-D metrology values may include multiplying the first error and the second error by an inverse projection Jacobian matrix iteratively to change the model parameters in order to minimize the error in mathematical model 200 with edges in the two camera images 220 and 222.

Generating 270 estimated 3-D metrology values may also include comparing the first error value and/or the second error value to a predefined error level. The predefined error level is a level of error where mathematical model 200 substantially matches the crystal growth features identified within first image 220 and/or second image 222. For example, if the errors are less than or equal to the predefined error level, at least one estimated dimension of the crystal growth feature may be generated 270 based on data within mathematical model 200. Determining that the first error and/or the second error are below a predefined level indicates that mathematical model 200 is a sufficiently accurate model of the actual crystal ingot 28, and therefore, dimensions present within mathematical model 200 may be relied on as corresponding to actual dimensions of crystal growth features. The estimated dimensions are used for controlling crystal growing apparatus 12. For example, the estimated dimensions may be provided to control unit 64 (shown in Figure 1) and used to determine crystal growing apparatus 12 operating parameters.

An arc of a circle of nearly uniform elevation may be used to detect a meniscus reflection within crystal growing apparatus 12 (i.e., bright ring 226). In an alternative embodiment, since bright ring 226 is a virtual image of crucible 16 (shown in Figure 1) plus heater brightness, a camera intersection above melt-gas interface 36 may be calculated, based on a shape of the meniscus, in order to further improve measurement accuracy. An example of a method for determining a camera intersection above a melt-gas interface is described in the following article, D.T.J. Hurle, Analytical Representation of the Shape of the Meniscus in Czochralski Growth, Journal of Crystal Growth, 63 (1983), p. 13-17. If the meniscus shape to be fitted is often affected by crystal distortions, then more general shape fitting may be used, such as spline fitting. Spline fitting is described in the following reference, A. Blake and M. Isard, Active Contours, Springer-Verlag, Berlin, 1998. In an alternative embodiment, a reflector feature is also determined. Examples of reflector features include, but are not limited to, a physical straight sharp edge, a linear rounded bump, a pointed feature or either of the linear features formed in an arc shape. Such reflector features may be used to determine reflector tilt, reflector rotation about vertical axis 38 (shown in Figure 1), and reflector lateral offset from vertical axis 38. A mathematical model that includes a level arc or a level straight line tangent to a radius of an arc may be sufficient to detect a reflector feature. However, if a measurement of the tilt of the reflector is also desired, then a model parameter may be added to the reflector model for tilt estimation. If in addition, the reflector feature is contained within a camera-centered notch in the reflector, the sides of the notch may be used to determine reflector rotation to improve the accuracy of straight edge feature elevation estimation, and the ingot sampling positions may thereby be adjusted to remain within the notch boundaries.

The first error and the second error are multiplied by an inverse projection Jacobian matrix and a sufficiently low gain to obtain an asymptotically stable approximation to actual crystal growth feature dimensions. Crystal growth feature dimensions, also referred to herein as metrology values, may include, but are not limited to, melt-level elevation 40, calibrated diameter 34 of crystal ingot 28, and an elevation of other hotzone features such as an elevation of a reflector edge having a known radius or diameter or a rotational position of a reflector edge within a reflector notch. A comparison of the elevation of the reflector edge and melt-level elevation 40 provides accurate and repeatable measurements of key crystal growth dimensions, such as melt gap 43 (shown in Figure 1). Such a reflector-melt surface gap is known to influence melt flow patterns and a gradient of the growing crystal ingot 28. Accurate and repeatable measurements of key crystal process dimensions facilitate adjusting crystal processing, for example, adjusting a crucible lift rate, based on the key crystal process dimensions.

If the first error value and/or the second error value are greater than the predefined error level, mathematical model 200 does not sufficiently match the actual crystal growth feature and therefore, mathematical model 200 can not be relied on as accurately representing dimensions of crystal ingot 28. In the exemplary embodiment, generating 270 an estimated 3-D metrology value further includes adjusting mathematical model 200 to compensate for the error between mathematical model 200 and the received images of actual crystal growth. Mathematical model 200 may be adjusted using the following formula:

$$WorldNew = WorldOld - G\frac{dW}{di}\left[\left(ProjectedWorldLocationsInImages\right) - \left(FeatureDectectionInImages\right)\right]$$

An inverse Jacobian approximation, dW/di, of a projection sensitivity matrix, is multiplied by a gain matrix, G, and the first and second camera image errors. In the exemplary embodiment, diagonal elements of the gain matrix, G, have values less than one and are selected to provide an asymptotic approximation to the measurement estimate. Large values in the gain matrix cause measurement instability, since the gain matrix is included in a feedback loop. The gain and inverse Jacobian approximation are generated during calibration of the camera/lens combination.

The adjusted mathematical model includes a plurality of adjusted model sample points. A plurality of feature normal points are determined for at least one of the plurality of adjusted model sample points. The plurality of feature normal points and the at least one of the plurality of adjusted model sample points define an adjusted sampling line. The adjusted sampling line is projected onto first image plane 180. Sampling is performed along the sampling line to determine a location of edge 224 of bright ring 226 within first image 220. A first error value is determined by comparing the location of edge 224 of bright ring 226 within first image 220 to the location of the adjusted model sample point. The adjusted sampling line is also projected onto second image plane 182. Sampling is performed along the adjusted sampling line to determine a location of edge 224 of bright ring 226 within second image 222. A second error value is determined by comparing the location of edge 224 of bright ring 226 within second image 222 to the location of the adjusted model sample point. If it is determined that the error between the adjusted model sample point and edge 224 of bright ring 226 within first image 220 and/or second image 222 is, for example, less than the predefined error level, an estimated dimension of a crystal feature based on the adjusted model sample points is output to control unit 64.

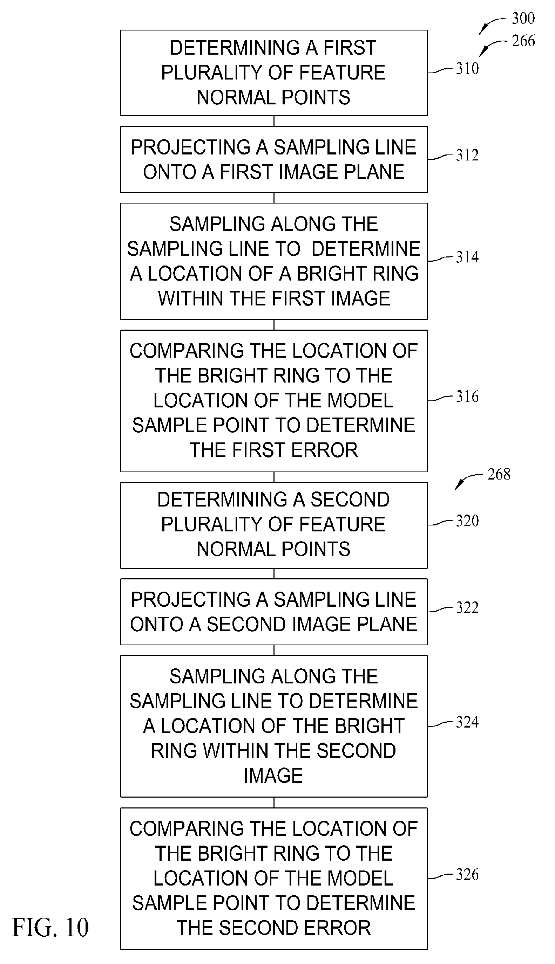

Figure 10 is a flow chart 300 of exemplary operations in determining 266 the first error value and determining 268 the second error value (shown in Figure 9). In the exemplary embodiment of Figure 10, determining 266 the first error value includes determining 310 a first plurality of feature normal points, for example, feature normal points 228, 230, and 232 (shown in Figure 7), for at least one of the plurality of model sample points 204, for example, model sample point 206. Feature normal points 228, 230, and 232 and model sample point 206 define a first sampling line, for example, sampling line 234 (shown in Figure 7). Sampling line 234 includes the plurality of feature normal points 228, 230, and 232 and model sample point 206. In the exemplary embodiment, sampling line 234 is orthogonal to a tangent of side 216 (shown in Figure 6) of mathematical model 200 and to a path to a center of camera lens 86 of first camera 80 from model sample point 206.

In the exemplary embodiment, determining 266 the first error value further includes projecting 312 sampling line 234 onto first image plane 180. Determining 266 also includes sampling 314 along sampling line 234 to determine a location of a brightness edge of a bright ring, for example bright ring 226 (shown in Figure 7) within first image 220. Determining 266 the first error value also includes comparing 316 the location of bright ring 226 within first image 220 to the location of model sample point 206. In other words, the first error is a vector between the location of bright ring 226 along sampling line 234 in first image 220 and the expected location of bright ring 226 according to mathematical model 200 (i.e., model sample point 206).

In the exemplary embodiment, determining 268 the second error value includes determining 320 a second plurality of feature normal points, for example, feature normal points 242, 244, and 246 (shown in Figure 8) for at least one of the plurality of model sample points 204, for example, model sample point 206. Feature normal points 242, 244, and 246 and model sample point 206 define a second sampling line, for example, sampling line 248 (shown in Figure 8). Sampling line 248 includes the plurality of feature normal points 242, 244, and 246 and model sample point 206. Sampling line 248 is orthogonal to a tangent of side 216 of mathematical model 200 and to a path to a center of camera lens 90 of second camera 82 from model sample point 206.

Determining 268 the second error value includes projecting 322 sampling line 248 onto second image plane 182. Determining 268 also includes sampling 324 along sampling line 248 to determine a location of edge 224 of bright ring 226 (shown in Figure 9) within second image 222. Determining 268 the second error value also includes comparing 326 the location of edge 224 of bright ring 226 within second image 222 to the location of model sample point 206.

A number of factors may degrade the accuracy and repeatability of a multiple camera metrology method for monitoring crystal growth. In addition to errors in mapping the cameras or camera assembly orientation accurately to the crystal furnace, lens thermal stability (e.g., plastic parts can melt, occluding or distorting the view), lens tightness against camera body (e.g., lens movement can distort or magnify the image, plus axial lens movement changes focus), movement of lens focus (e.g., changes image size on camera image plane), mechanical movement of one camera body relative to the other after the calibration, mechanical movement of a camera image plane relative to the lens, and blooming of image pixels into adjacent pixels by image saturation each can affect measurement accuracy and repeatability. These parameters, if uncontrolled, may generate errors in mathematical model fitting. These factors may be minimized by thermal protection (e.g., insulation blocking excess radiation to the cameras, thermally reflective glass between lens and process, for example, partially gold or silver coating), use of dimensionally stable camera mounting materials in the presence of a thermal gradient, full tightening of lenses, locking of focus, secure and stable tightening of cameras onto mount, and brightness adjustment using f-stop to prevent image saturation during the process. A shift or a drift in camera calibration accuracy can be determined by monitoring the first error and the second error over time. For example, an average first error over time and/or an average second error over time may be calculated. An average that is greater than a predicted average may be an indication that first camera 80 and/or second camera 82 have shifted relative to camera mounting system 162, that a camera image plane has moved relative to a lens, and/or any other mechanical movement has occurred that prevents control system 10 from functioning as described herein.

Furthermore, one or more computer-readable media having computer-executable components, may be configured for three-dimensional measurement of a growing crystal, for example, crystal ingot 28 (shown in Figure 1). The computer-executable components may include: an interface component that, when executed by at least one processor, causes the at least one processor to receive image data captured by a first camera and a second camera, the image data representing a first image captured on an image plane of the first camera and a second image captured on an image plane of the second camera; a memory component that, when executed by at least one processor, causes the at least one processor to store a mathematical model of a crystal during crystal growth, the mathematical model including a plurality of model sample points that correspond to at least one feature of the growing crystal; and an analysis component that, when executed by at least one processor, causes the at least one processor to determine an estimated metrology value of the at least one feature of the growing crystal.

The analysis component further: determines a plurality of feature normal points for a first model sample point of the plurality of model sample points, the plurality of feature normal points and the first model sample point define a sampling line; projects the sampling line onto the image plane of the first camera; samples along the sampling line to determine a location of a bright ring within the first image; determines a first error value by comparing the location of the bright ring to the location of the first model sample point; projects a different sampling line passing through the same sampling point onto the image plane of the second camera; samples along the sampling line to determine a location of the bright ring within the second image; determines a second error value by comparing the location of the bright ring to the location of the first model sample point; and based on the determined first error value and the determined second error value, generates, by iterative adjustment of the mathematical model, the estimated metrology value associated with the at least one feature of the growing crystal.

The analysis component may be configured to determine that the first error value and the second error value are less than or equal to a predefined error level and to output an estimated metrology value for the at least one crystal growth feature. The analysis component may further be configured to determine that the first error value and the second error value are above the predefined error level and generate world model adjustment values by applying a gain matrix to the first error and the second error.

Moreover, the analysis component may be configured to: generate an adjusted world model by adjusting the mathematical model in accordance with the world model adjustment values, the adjusted world model comprising a plurality of adjusted model sample points; determine a plurality of feature normal points for a first adjusted model sample point of the plurality of adjusted model sample points, the plurality of feature normal points and the first adjusted model sample point define a sampling line; project the sampling line onto the image plane of the first camera; sample along the sampling line to determine a location of a bright ring within the first image; determine a first error value by comparing the location of the bright ring to the location of the first adjusted model sample point; project the sampling line onto the image plane of the second camera; sample along the sampling line to determine a location of the bright ring within the second image; determine a second error value by comparing the location of the bright ring to the location of the first adjusted model sample point; and based on the determined first error value and the determined second error value, generate, from the adjusted world model, the estimated metrology value associated with the at least one feature of the growing crystal. The calibrating component, when executed by at least one processor, may cause the at least one processor to generate a calibration parameter dataset for the first camera and a calibration parameter dataset for the second camera, the calibration parameter dataset used to project the sampling lines onto the image planes of the first and second cameras and to generate the adjusted world model.

The embodiments described herein provide real-time fitting of mathematical models, such as an expected outer periphery of a crystal diameter, to images captured by two cameras. The real-time fitting may be performed by sampling the mathematical model at a group of points, generating a mathematical vector from a model sample point through a first camera lens center and a second camera lens center and onto each of the camera image planes using the camera calibration parameters for each camera plus lens combination. Additional sample points may be generated which define a short bi-directional mathematical line (i.e., sampling line) that is orthogonal to a tangent of the model surface and to the path to the camera lens center from the model sample point. The projection of endpoints of the sampling line onto the image plane obtains endpoints of a line that can be sampled to locate an edge of a bright ring. Interpixel sampling along the sampling line on the camera image plane facilitates determining a maximum brightness gradient that corresponds to a location of the edge of the bright ring in the image, wherein the bright ring is representative of a virtual image (i.e., reflection) of a physical edge (e.g., outer edge of a bottom of a reflector) as it is growing in the crystal growing apparatus.

A difference between the location of the bright ring detected within the image and the projection of the model sample point defines an error. For each sample point of the mathematical model, such an error may be generated using each camera image. Since the camera projections cannot be collinear when using two physical cameras, information is present in the two errors about orthogonal errors in the mathematical model. Multiplying the errors by the inverse projection Jacobian and a sufficiently low gain will obtain an asymptotically stable approximation to model parameters. Example measurements include a melt elevation of a reflective meniscus, a calibrated diameter of the reflective meniscus, and an elevation of other hotzone features such as an elevation of a reflector edge having a known radius or diameter, dimensions of which may be included in the mathematical model.

A comparison of the elevation of the reflector edge and the melt elevation facilitate determining accurate and repeatable measurements of key crystal process dimensions, for example, but not limited to, a gap between the bottom of a melt reflector and the melt surface. Such a gap, in combination with argon flow velocity, is known to influence melt flow patterns, a gradient of the growing crystal, crystal length, and interface shape. Once accurate and repeatable measurements have been generated of a reflector to melt gap, then the measurement may be controlled by adjusting operation of the crystal growing apparatus, for example, by modulating the crucible lift rate.

Described herein are exemplary embodiments of three-dimensional measurement of an actual parameter value of a growing crystal being pulled from a crucible. More specifically, the embodiments described herein enable measurement of multiple parameter values using two cameras. The embodiments described herein facilitate providing crystal growth data to a control system that applies the received crystal growth data to ongoing operation of the crystal growing apparatus.

The embodiments described herein facilitate efficient and economical crystal growth. Exemplary embodiments are described and/or illustrated herein in detail. The disclosure is not limited to the specific embodiments described herein, but rather, components of each system, as well as the operations in each method, may be utilized independently and separately from other components and operations described herein. Each component, and each operation, can also be used in combination with other components and/or method operations.

It should be noted that the embodiments described herein are not limited to any particular processor for performing the described processing tasks. The term "processor," as that term is used herein, is intended to denote any machine capable of performing the calculations, or computations, necessary to perform the tasks described herein. The term "processor" also is intended to denote any machine that is capable of accepting a structured input and of processing the input in accordance with prescribed rules to produce an output.

The embodiments described herein embrace one or more computer readable media, wherein each medium may be configured to include or includes thereon data or computer executable instructions for manipulating data. The computer executable instructions include data structures, objects, programs, routines, or other program modules that may be accessed by a processing system, such as one associated with a general-purpose computer capable of performing various different functions or one associated with a special-purpose computer capable of performing a limited number of functions. Computer executable instructions cause the processing system to perform a particular function or group of functions and are examples of program code means for implementing steps for methods disclosed herein. Furthermore, a particular sequence of the executable instructions provides an example of corresponding acts that may be used to implement such steps. Examples of computer readable media include random-access memory ("RAM"), read-only memory ("ROM"), programmable read-only memory ("PROM"), erasable programmable read-only memory ("EPROM"), electrically erasable programmable read-only memory ("EEPROM"), compact disk read-only memory ("CD-ROM"), or any other device or component that is capable of providing data or executable instructions that may be accessed by a processing system.

A computer or computing device such as described herein has one or more processors or processing units, system memory, and some form of computer readable media. By way of example and not limitation, computer readable media comprise computer storage media and communication media. Computer storage media include volatile and nonvolatile, removable and non-removable media implemented in any method or technology for storage of information such as computer readable instructions, data structures, program modules or other data. Communication media typically embody computer readable instructions, data structures, program modules, or other data in a modulated data signal such as a carrier wave or other transport mechanism and include any information delivery media. Combinations of any of the above are also included within the scope of computer readable media.

The computer may operate in a networked environment using logical connections to one or more remote computers, such as a remote computer. Although described in connection with an exemplary computing system environment, embodiments of the invention are operational with numerous other general purpose or special purpose computing system environments or configurations. The computing system environment is not intended to suggest any limitation as to the scope of use or functionality of any aspect of the invention. Moreover, the computing system environment should not be interpreted as having any dependency or requirement relating to any one or combination of components illustrated in the exemplary operating environment. Examples of well known computing systems, environments, and/or configurations that may be suitable for use with aspects of the invention include, but are not limited to, personal computers, server computers, hand-held or laptop devices, multiprocessor systems, microprocessor-based systems, set top boxes, programmable consumer electronics, mobile telephones, network PCs, minicomputers, mainframe computers, distributed computing environments that include any of the above systems or devices, and the like.

Embodiments described herein may be described in the general context of computer-executable instructions, such as program modules, executed by one or more computers or other devices. The computer-executable instructions may be organized into one or more computer-executable components or modules. Generally, program modules include, but are not limited to, routines, programs, objects, components, and data structures that perform particular tasks or implement particular abstract data types. Aspects of the disclosure described herein may be implemented with any number and organization of such components or modules. For example, aspects of the disclosure are not limited to the specific computer-executable instructions or the specific components or modules illustrated in the figures and described herein. Other embodiments may include different computer-executable instructions or components having more or less functionality than illustrated and described herein. Aspects of the disclosure may also be practiced in distributed computing environments where tasks are performed by remote processing devices that are linked through a communications network. In a distributed computing environment, program modules may be located in both local and remote computer storage media including memory storage devices.

Aspects of the disclosure transform a general-purpose computer into a special-purpose computing device when configured to execute the instructions described herein.

When introducing elements/components/etc. of the methods and systems described and/or illustrated herein, the articles "a", "an", "the", and "said" are intended to mean that there are one or more of the element(s)/component(s)/etc. The terms "comprising", "including", and "having" are intended to be inclusive and mean that there may be additional element(s)/component(s)/etc. other than the listed element(s)/component(s)/etc.

A method for three-dimensional (3-D) measurement of a growing crystal being pulled from a crucible is described herein. A first camera captures a first image of the growing crystal on a first image plane and a second camera captures a second image of the growing crystal on a second image plane. The method includes: generating a mathematical model of a crystal during crystal growth, the mathematical model including a plurality of model sample points; detecting at least one crystal growth feature within the first image and the second image; determining a first error value by comparing the mathematical model to the at least one crystal growth feature within the first image and a second error value by comparing the mathematical model to the at least one crystal growth feature within the second image; and generating an estimated 3-D metrology value associated with the at least one crystal growth feature by adjusting the mathematical model to minimize the determined first error value and the determined second error value.

Determining the first error value and the second error value may include determining a plurality of feature normal points for at least one of the plurality of model sample points, the plurality of feature normal points define a sampling line that includes the plurality of feature normal points and the at least one of the plurality of model sample points. The sampling line is orthogonal to a tangent of a surface of the mathematical model and to a path to a camera lens center of at least one of the first camera and the second camera from the model sample point.

Determining the first error value and the second error value may also include projecting the sampling line onto the first image plane; sampling along the sampling line to determine a location of an edge of a bright ring on the first image plane; determining the first error value by comparing the location of the edge of the bright ring to the at least one of the plurality of model sample points; projecting the sampling line onto the second image plane; sampling along the sampling line to determine a location of the edge of the bright ring on the second image plane; and determining the second error value by comparing the location of the edge of the bright ring to the at least one of the plurality of model sample points.

Generating an estimated metrology value may include determining that the first error value and the second error value are equal to or less than a predefined error level that corresponds to a sufficiently accurate model of the crystal.

The method for three-dimensional (3-D) measurement of a growing crystal being pulled from a crucible may also include determining that the first error value and the second error value are greater than the predefined error level; generating mathematical model adjustment values by applying a gain matrix to the first error value and the second error value; generating an adjusted mathematical model by adjusting the mathematical model in accordance with the mathematical model adjustment values, the adjusted mathematical model comprising a plurality of adjusted model sample points; determining a plurality of feature normal points for at least one of the plurality of adjusted model sample points, the plurality of feature normal points and the at least one of the plurality of adjusted model sample points defining an adjusted sampling line; projecting the adjusted sampling line onto the first image plane; sampling along the sampling line to determine the location of the edge of the bright ring on the first image plane; determining the first error value by comparing the location of the edge of the bright ring to the at least one of the plurality of adjusted model sample points; projecting the adjusted sampling line onto the second image plane; sampling along the adjusted sampling line to determine the location of the edge of the bright ring on the second image plane; determining the second error value by comparing the location of the edge of the bright ring to the at least one of the plurality of adjusted model sample points; determining that the first error value and the second error value are less than or equal to a predefined error level; and generating an adjusted estimated metrology value of the at least one crystal growth feature based on the plurality of adjusted model sample points.

The method may also include generating an assumed mathematical model reference on which the mathematical model is centered. Furthermore, the plurality of points of the mathematical model represent at least one crystal growth feature, wherein the at least one feature includes at least one of a crystal diameter, a melt-level elevation, an elevation of a reflector edge having a known radius or diameter, and a position of a reflector edge within a reflector notch.

The method may also include calibrating the first camera and the second camera, wherein calibrating comprises generating a calibration parameter dataset used in determining the plurality of feature normal points for at least one of the plurality of model sample points.

Generating a mathematical model of a crystal during crystal growth may include generating a plurality of points each having three-dimensional coordinates. Moreover, generating an estimated metrology value of at least one crystal features may include generating at least one of an estimated crystal diameter, an estimated melt elevation, and an estimated melt-reflector gap length.

Also described herein is a system for measuring a crystal growth feature during crystal growth. The system includes: a first camera configured to capture a first image of the crystal during growth on a first image plane; a second camera configured to capture a second image of the crystal during growth on a second image plane; and a processing device communicatively coupled to the first camera and the second camera. The processing device is programmed to: generate a mathematical model of a crystal during crystal growth, the mathematical model comprising a plurality of model sample points including a first model sample point; detect at least one crystal growth feature within the first image and the second image; determine a first error value by comparing the mathematical model to the crystal growth feature in the first image and a second error value by comparing the mathematical model to the crystal growth feature in the second image; and based on the determined first error value and the determined second error value, generating, from the mathematical model, an estimated metrology value associated with the at least one crystal growth feature.

The system also includes a calibration system configured to generate a first calibration parameter dataset for the first camera and a second calibration parameter dataset for the second camera. The processing device is further configured to determine that the first error value and the second error value are less than or equal to a predefined error level and output an estimated metrology value of the crystal growth feature based on the mathematical model. The processing device is further configured to: determine that the first error value and the second error value are greater than the predefined error level; and generate mathematical model adjustment values by applying a gain matrix to the first error value and the second error value, the gain matrix including data from a sensitivity analysis of the calibration parameter datasets.

Furthermore, the processing device is configured to determine a first plurality of feature normal points for the first model sample point, the feature normal points define a sampling line that includes the plurality of feature normal points and the first model sample point, the sampling line is orthogonal to a tangent of a surface of the mathematical model and to a path to a center of the first camera from the first model sample point. Moreover, the processing device is further configured to: project the sampling line onto the first image plane; sample along the sampling line to determine a location of an edge of a bright ring within the first image; determine the first error by comparing the location of the edge of the bright ring to the first model sample point; project the sampling line onto the second image plane; sample along the sampling line to determine a location of the edge of the bright ring within the second image; and determine the second error by comparing the location of the edge of the bright ring to the first model sample point.

**Claims**

1. A system for measuring a crystal during crystal growth, the system comprising:

   a first camera (80) configured to capture a first image of the crystal during growth on a first image plane;
   a second camera (82) configured to capture a second image of the crystal during growth on a second image plane; and
   a processing device (110) communicatively coupled to said first camera and said second camera and programmed to:

      generate a mathematical model of a crystal during crystal growth, the mathematical model comprising a plurality of model sample points including a first model sample point;
      detect at least one crystal growth feature within the first image and the second image;
      determine a first error value by comparing the mathematical model to the crystal growth feature in the first image and a second error value by comparing the mathematical model to the crystal growth feature in the second image; and

generating from the mathematical model, and based on the determined first error value and the determined second error value, an estimated metrology value associated with the at least one crystal growth feature.

2. A system in accordance with Claim 1, wherein at least one of the first camera and the second camera comprises a discrete digital camera, preferably wherein the discrete digital camera comprises at least one of a serial digital camera and a parallel digital camera.

3. A system in accordance with Claim 1 or 2 further comprising a calibration system (170) configured to generate a first calibration parameter dataset for the first camera and a second calibration parameter dataset for the second camera.

4. A system in accordance with any one of Claims 1 to 3, wherein said processing device is further configured to determine that the first error value and the second error value are less than or equal to a predefined error level and output an estimated metrology value of the crystal growth feature based on the mathematical model.

5. A system in accordance with any one of Claims 1 to 3, wherein said processing device is further configured to:

determine that the first error value and the second error value are greater than a predefined error level; and generate mathematical model adjustment values by applying a gain matrix to the first error value and the second error value, the gain matrix including data from the calibration parameter datasets.

6. A system in accordance with any one of Claims 1 to 5, wherein said processing device is further configured to determine a first plurality of feature normal points for the first model sample point, the feature normal points define a sampling line that includes the plurality of feature normal points and the first model sample point, the sampling line is orthogonal to a tangent of a surface of the mathematical model and to a path to a center of the first camera from the first model sample point,

wherein preferably said processing device is further configured to:

project the sampling line onto the first image plane; sample along the sampling line to determine a location of a bright ring within the first image; determine the first error by comparing the location of the bright ring to the first model sample point; project the sampling line onto the second image plane; sample along the sampling line to determine a location of the bright ring within the second image; and determine the second error by comparing the location of the bright ring to the first model sample point.

7. A method for three-dimensional measurement of a growing crystal being pulled from a crucible, wherein a first camera (80) captures a first image of the growing crystal on a first image plane and a second camera (82) captures a second image of the growing crystal on a second image plane, the method comprising:

generating a mathematical model of a crystal during crystal growth, the mathematical model including a plurality of model sample points; detecting at least one crystal growth feature within the first image and the second image; determining a first error value by comparing the mathematical model to the at least one crystal feature within the first image and a second error value by comparing the mathematical model to the at least one crystal feature within the second image; and generating from the mathematical model, and based on the determined first error value and the determined second error value, an estimated metrology value associated with the at least one crystal feature.

8. A method in accordance with Claim 7, wherein determining the first error value and the second error value includes determining a plurality of feature normal points for at least one of the plurality of model sample points, the plurality of feature normal points define a sampling line that includes the plurality of feature normal points and the at least one of the plurality of model sample points,

wherein preferably the sampling line is orthogonal to a tangent of a surface of the mathematical model and to a path to a camera lens center of at least one of the first camera and the second camera from the model sample point.

9. A method in accordance with Claim 8, wherein determining the first error value and the second error value comprises:

projecting the sampling line onto the first image plane;
sampling along the sampling line to determine a location of a bright ring on the first image plane;
determining the first error value by comparing the location of the bright ring to the at least one of the plurality of model sample points;
projecting the sampling line onto the second image plane;
sampling along the sampling line to determine a location of the bright ring on the second image plane; and
determining the second error value by comparing the location of the bright ring to the at least one of the plurality of model sample points.

10. A method in accordance with any one of Claims 7 to 9, wherein generating an estimated metrology value comprises determining that the first error value and the second error value are equal to or less than a predefined error level.

11. A method in accordance with any one of Claims 7 to 9 further comprising:

determining that the first error value and the second error value are greater than a predefined error level;
generating mathematical model adjustment values by applying a gain matrix to the first error value and the second error value;
generating an adjusted mathematical model by adjusting the mathematical model in accordance with the mathematical model adjustment values, the adjusted mathematical model comprising a plurality of adjusted model sample points;
determining a plurality of feature normal points for at least one of the plurality of adjusted model sample points, the plurality of feature normal points and the at least one of the plurality of adjusted model sample points defining an adjusted sampling line;
projecting the adjusted sampling line onto the first image plane;
sampling along the sampling line to determine a location of a bright ring on the first image plane;
determining the first error value by comparing the location of the bright ring to the at least one of the plurality of adjusted model sample points;
projecting the adjusted sampling line onto the second image plane;
sampling along the adjusted sampling line to determine a location of the bright ring on the second image plane;
determining the second error value by comparing the location of the bright ring to the at least one of the plurality of adjusted model sample points;
determining that the first error value and the second error value are less than or equal to a predefined error level; and
generating an adjusted estimated metrology value of the at least one crystal growth feature based on the plurality of adjusted model sample points.

12. A method in accordance with any one of Claims 7 to 11 further comprising generating an assumed mathematical model reference on which the mathematical model is centered.

13. A method in accordance with any one of Claims 7 to 12, wherein the plurality of points of the mathematical model represent at least one feature of a crystal, wherein the at least one feature includes at least one of a crystal diameter, a melt elevation, and a reflector elevation.

14. A method in accordance with any one of Claims 7 to 13 further comprising calibrating the first camera and the second camera, wherein calibrating comprises generating a calibration parameter dataset used in determining the plurality of feature normal points for at least one of the plurality of model sample points.

15. A method in accordance with any one of Claims 7 to 14, wherein generating a mathematical model of a crystal during crystal growth comprises generating a plurality of points each having three-dimensional coordinates.

16. A method in accordance with any one of Claims 7 to 15, wherein generating an estimated metrology value of at least one crystal features includes generating at least one of an estimated crystal diameter, an estimated melt elevation, and an estimated melt-reflector gap length.

**Patentansprüche**

1. Ein System zur Vermessung eines Kristalls während des Kristallwachstums, wobei dieses System umfasst:

eine erste Kamera (80), die so konfiguriert ist, dass sie ein erstes Bild des Kristalls während des Wachstums in einer ersten Bildebene aufnimmt;

eine zweite Kamera (82), die so konfiguriert ist, dass sie ein zweites Bild des Kristalls während des Wachstums in einer zweiten Bildebene aufnimmt; und

eine Prozessierungsvorrichtung (110), die zur Kommunikation mit dieser ersten Kamera und mit dieser zweiten Kamera gekoppelt ist, und die programmiert ist um:

ein mathematisches Modell eines Kristalls während des Kristallwachstums zu generieren, wobei das mathematische Modell eine Vielzahl von Modell-Bezugspunkten einschließlich eines ersten Modell-Bezugspunkts umfasst;

wenigstens ein Kristallwachstums-Merkmal innerhalb des ersten Bildes und des zweiten Bildes zu ermitteln;

einen ersten Abweichungswert festzustellen durch Vergleich des mathematischen Modells mit dem Kristallwachstums-Merkmal in dem ersten Bild, und einen zweiten Abweichungswert festzustellen durch Vergleich des mathematischen Modells mit dem Kristallwachstums-Merkmal in dem zweiten Bild; und

aus dem mathematischen Modell, und basierend auf dem festgestellten ersten Abweichungswert und dem festgestellten zweiten Abweichungswert, einen geschätzten Messwert zu generieren, der mit dem wenigstens einen Kristallwachstums-Merkmal assoziiert ist.

2. Ein System gemäß Anspruch 1, wobei wenigstens eine Kamera von erster und zweiter Kamera eine gesonderte Digitalkamera umfasst, wobei vorzugsweise die gesonderte Digitalkamera wenigstens eine Kamera umfasst, die eine seriell geschaltete Digitalkamera oder eine parallel geschaltete Digitalkamera ist.

3. Ein System gemäß Anspruch 1 oder 2, des Weiteren umfassend ein Kalibriersystem (170), das so konfiguriert ist, dass es ein erstes Kalibrierungsparameter-Daten-Set für die erste Kamera und ein zweites Kalibrierungsparameter-Daten-Set für die zweite Kamera generiert.

4. Ein System gemäß irgendeinem der Ansprüche 1 bis 3, wobei die Prozessierungsvorrichtung des Weiteren so konfiguriert ist, dass sie feststellen kann, ob der erste Abweichungswert und der zweite Abweichungswert unter oder gleich einer vorher festgelegten Abweichungsgrenze sind, und einen geschätzten Messwert des Kristallwachstums-Merkmals basierend auf dem mathematischen Modell ausgeben kann.

5. Ein System gemäß irgendeinem der Ansprüche 1 bis 3, wobei die Prozessierungsvorrichtung des Weiteren so konfiguriert ist, dass sie:

feststellen kann, ob der erste Abweichungswert und der zweite Abweichungswert höher als eine vorher festgelegte Abweichungsgrenze sind; und

Werte zur Anpassung des mathematischen Modells generieren kann, indem sie eine Zunahme-Matrix auf den ersten Abweichungswert und den zweiten Abweichungswert anwendet, wobei die Zunahme-Matrix Daten aus den Kalibrierungsparameter-Daten-Sets beinhaltet.

6. Ein System gemäß irgendeinem der Ansprüche 1 bis 5, wobei die Prozessierungsvorrichtung des Weiteren so konfiguriert ist, dass sie eine erste Vielzahl von Merkmals-Normalpunkten für den ersten Modell-Bezugspunkt feststellt, wobei die Merkmals-Normalpunkte eine Messlinie definieren, welche die Vielzahl von Merkmals-Normalpunkten und den ersten Modell-Bezugspunkt einschließt, wobei die Messlinie orthogonal zu einer Tangente einer Oberfläche des mathematischen Modells und zu einer Linie von dem ersten Modell-Bezugspunkt zu einer Mitte der ersten Kamera steht,

wobei vorzugsweise die Prozessierungsvorrichtung des Weiteren so konfiguriert ist, dass sie:

die Messlinie auf die erste Bildebene projizieren kann;

entlang der Messlinie messen kann, um einen hellen Ring innerhalb des ersten Bildes zu lokalisieren;

die erste Abweichung feststellen kann, indem sie die Lage des hellen Rings mit dem ersten Modell-Bezugspunkt vergleicht;

die Messlinie auf die zweite Bildebene projizieren kann;

entlang der Messlinie messen kann, um den hellen Ring innerhalb des zweiten Bildes zu lokalisieren; und

die zweite Abweichung feststellen kann, indem sie die Lage des hellen Rings mit dem ersten Modell-Bezugspunkt vergleicht.

7. Ein Verfahren zur dreidimensionalen Vermessung eines wachsenden Kristalls, der aus einem Tiegel gezogen wird, wobei eine erste Kamera (80) ein erstes Bild des wachsenden Kristalls in einer ersten Bildebene aufnimmt und eine zweite Kamera (82) ein zweites Bild des wachsenden Kristalls in einer zweiten Bildebene aufnimmt, wobei dieses Verfahren umfasst:

das Generieren eines mathematisches Modells eines Kristalls während des Kristallwachstums, wobei das mathematische Modell eine Vielzahl von Modell-Bezugspunkten umfasst;
das Ermitteln wenigstens eines Kristallwachstums-Merkmal innerhalb des ersten Bildes und des zweiten Bildes;
das Feststellen eines ersten Abweichungswerts durch Vergleich des mathematischen Modells mit dem wenigstens einen Kristallwachstums-Merkmal in dem ersten Bild, und eines zweiten Abweichungswerts durch Vergleich des mathematischen Modells mit dem wenigstens einen Kristallwachstums-Merkmal in dem zweiten Bild; und
das Generieren eines geschätzten Messwerts aus dem mathematischen Modell, und basierend auf dem festgestellten ersten Abweichungswert und dem festgestellten zweiten Abweichungswert, wobei der geschätzte Messwert mit dem wenigstens einen Kristallwachstums-Merkmal assoziiert ist.

8. Ein Verfahren gemäß Anspruch 7, wobei das Feststellen des ersten Abweichungswerts und des zweiten Abweichungswerts das Feststellen einer Vielzahl von Merkmals-Normalpunkten für wenigstens einen der Vielzahl von Modell-Bezugspunkten einschließt, wobei die Vielzahl von Merkmals-Normalpunkten eine Messlinie definieren, welche die Vielzahl von Merkmals-Normalpunkten und den wenigstens einen der Vielzahl von Modell-Bezugspunkten einschließt,
wobei vorzugsweise die Messlinie orthogonal zu einer Tangente einer Oberfläche des mathematischen Modells und zu einer Linie von dem Modell-Bezugspunkt zu einer Kameralinsen-Mitte von wenigstens einer Kamera von erster und zweiter Kamera steht.

9. Ein Verfahren gemäß Anspruch 8, wobei das Feststellen des ersten Abweichungswerts und des zweiten Abweichungswerts umfasst:

das Projizieren der Messlinie auf die erste Bildebene;
das Messen entlang der Messlinie, um einen hellen Ring innerhalb der ersten Bildebene zu lokalisieren;
das Feststellen des ersten Abweichungswerts durch Vergleich der Lage des hellen Rings mit dem wenigstens einen der Vielzahl von Modell-Bezugspunkten;
das Projizieren der Messlinie auf die zweite Bildebene;
das Messen entlang der Messlinie, um den hellen Ring innerhalb der zweiten Bildebene zu lokalisieren; und
das Feststellen des zweiten Abweichungswerts durch Vergleich der Lage des hellen Rings mit dem wenigstens einen der Vielzahl von Modell-Bezugspunkten.

10. Ein Verfahren gemäß irgendeinem der Ansprüche 7 bis 9, wobei das Generieren eines geschätzten Messwerts das Feststellen umfasst, ob der erste Abweichungswert und der zweite Abweichungswert unter oder gleich einer vorher festgelegten Abweichungsgrenze sind.

11. Ein Verfahren gemäß irgendeinem der Ansprüche 7 bis 9, des Weiteren umfassend:

das Feststellen, ob der erste Abweichungswert und der zweite Abweichungswert höher als eine vorher festgelegte Abweichungsgrenze sind;
das Generieren von Werten zur Anpassung des mathematischen Modells, indem eine Zunahme-Matrix auf den ersten Abweichungswert und den zweiten Abweichungswert angewandt wird;
das Generieren eines angepassten mathematischen Modells durch Anpassung des mathematischen Modells entsprechend der Werte zur Anpassung des mathematischen Modells, wobei das angepasste mathematische Modell eine Vielzahl von angepassten Modell-Bezugspunkten umfasst;
das Feststellen einer Vielzahl von Merkmals-Normalpunkten für wenigstens einen der Vielzahl von angepassten Modell-Bezugspunkten, wobei die Vielzahl der Merkmals-Normalpunkte und der wenigstens eine der Vielzahl von angepassten Modell-Bezugspunkten eine angepasste Messlinie definieren;
das Projizieren der angepassten Messlinie auf die erste Bildebene;
das Messen entlang der Messlinie, um einen hellen Ring innerhalb der ersten Bildebene zu lokalisieren;
das Feststellen des erstes Abweichungswerts durch Vergleich der Lage des hellen Rings mit dem wenigstens einen der Vielzahl von angepassten Modell-Bezugspunkten;
das Projizieren der angepassten Messlinie auf die zweite Bildebene;
das Messen entlang der angepassten Messlinie, um den hellen Ring innerhalb der zweiten Bildebene zu lokalisieren;

das Feststellen des zweiten Abweichungswerts durch Vergleich der Lage des hellen Rings mit dem wenigstens einen der Vielzahl von angepassten Modell-Bezugspunkten;

das Feststellen, ob der erste Abweichungswert und der zweite Abweichungswert unter oder gleich einer vorher festgelegten Abweichungsgrenze sind; und

das Generieren eines angepassten geschätzten Messwerts des wenigstens einen Kristallwachstums-Merkmals basierend auf der Vielzahl der angepassten Modell-Bezugspunkte.

**12.** Ein Verfahren gemäß irgendeinem der Ansprüche 7 bis 11, des Weiteren umfassend das Generieren einer virtuellen Referenz für das mathematische Modell, auf die das mathematische Modell zentriert ist.

**13.** Ein Verfahren gemäß irgendeinem der Ansprüche 7 bis 12, wobei die Vielzahl der Punkte des mathematischen Modells wenigstens ein Merkmal eines Kristalls repräsentieren, wobei dieses wenigstens eine Merkmal wenigstens ein Merkmal aus Kristalldurchmesser, Schmelzerhebung, und Reflektorerhebung umfasst.

**14.** Ein Verfahren gemäß irgendeinem der Ansprüche 7 bis 13, des Weiteren umfassend die Kalibrierung der ersten Kamera und der zweiten Kamera, wobei die Kalibrierung das Generieren eines Kalibrierungsparameter-Daten-Sets umfasst, das verwendet wird, um die Vielzahl der Merkmals-Normalpunkte für wenigstens einen der Vielzahl von Modell-Bezugspunkten festzustellen.

**15.** Ein Verfahren gemäß irgendeinem der Ansprüche 7 bis 14, wobei das Generieren eines mathematischen Modells eines Kristalls während des Kristallwachstums das Generieren einer Vielzahl von Punkten umfasst, die alle jeweils dreidimensionale Koordinaten haben.

**16.** Ein Verfahren gemäß irgendeinem der Ansprüche 7 bis 15, wobei das Generieren eines geschätzten Messwerts für wenigstens ein Kristall-Merkmal das Generieren von wenigstens einem Merkmal aus geschätztem Kristalldurchmesser, geschätzter Schmelzerhebung, und geschätztem Abstand zwischen Schmelze und Reflektor umfasst.

## Revendications

**1.** Système de mesure d'un cristal pendant la croissance du cristal, le système comprenant :

un premier appareil photo (80) configuré pour capturer une première image du cristal pendant la croissance sur un premier plan d'image ;

un second appareil photo (82) configuré pour capturer une seconde image du cristal pendant la croissance sur un second plan d'image ; et

un dispositif de traitement (110) couplé de manière communicative audit premier appareil photo et audit second appareil photo et programmé pour :

générer un modèle mathématique d'un cristal pendant la croissance du cristal, le modèle mathématique comprenant une pluralité de points d'échantillonnage de modèle comprenant un premier point d'échantillonnage du modèle ;

détecter au moins une caractéristique de croissance des cristaux au sein de la première image et de la seconde image ;

déterminer une première valeur d'erreur en comparant le modèle mathématique à la caractéristique de croissance des cristaux dans la première image et une seconde valeur d'erreur en comparant le modèle mathématique à la caractéristique de croissance des cristaux dans la seconde image ; et

générer à partir du modèle mathématique, et sur la base de la première valeur d'erreur déterminée et de la seconde valeur d'erreur déterminée, une valeur estimée de métrologie associée à la au moins une caractéristique de croissance des cristaux.

**2.** Système selon la revendication 1, dans lequel au moins l'un du premier appareil photo et du second appareil photo comprend un appareil photo numérique discret, de manière préférée dans lequel l'appareil photo numérique discret comporte au moins l'un d'un appareil photo numérique série et d'un appareil photo numérique parallèle.

**3.** Système selon la revendication 1 ou 2, comprenant en outre un système d'étalonnage (170) configuré pour générer un premier ensemble de données de paramètres d'étalonnage pour le premier appareil photo et un deuxième ensemble de données de paramètres d'étalonnage pour le second appareil photo.

**4.** Système selon l'une quelconque des revendications 1 à 3, dans lequel ledit dispositif de traitement est en outre configuré pour déterminer que la première valeur d'erreur et la seconde valeur d'erreur sont inférieures ou égales à un niveau d'erreur prédéfini et délivrer en sortie une valeur de métrologie estimée de la caractéristique de croissance des cristaux sur la base du modèle mathématique.

**5.** Système selon l'une quelconque des revendications 1 à 3, dans lequel ledit dispositif de traitement est en outre configuré pour :

déterminer que la première valeur d'erreur et la seconde valeur d'erreur sont supérieures à un niveau d'erreur prédéfini ; et
générer des valeurs d'ajustement de modèle mathématique en appliquant une matrice de gain à la première valeur d'erreur et à la seconde valeur d'erreur, la matrice de gain comprenant des données provenant des ensembles de données de paramètres d'étalonnage.

**6.** Système selon l'une quelconque des revendications 1 à 5, dans lequel ledit dispositif de traitement est en outre configuré pour déterminer une première pluralité de points normaux de caractéristique pour le premier point d'échantillonnage du modèle, les points normaux de caractéristique définissent une ligne d'échantillonnage qui comprend la pluralité de points normaux de caractéristique et le premier point d'échantillonnage de modèle, la ligne d'échantillonnage est orthogonale à une tangente d'une surface du modèle mathématique et à un chemin d'accès à un centre du premier appareil photo à partir du premier point d'échantillonnage du modèle, dans lequel ledit dispositif de traitement est en outre configuré pour :

projeter la ligne d'échantillonnage sur le premier plan d'image ;
effectuer un échantillonnage le long de la ligne d'échantillonnage afin de déterminer un emplacement d'un anneau brillant dans la première image ;
déterminer la première erreur en comparant l'emplacement de l'anneau brillant au premier point d'échantillonnage du modèle ;
projeter la ligne d'échantillonnage sur le second plan image ;
effectuer un échantillonnage le long de la ligne d'échantillonnage afin de déterminer un emplacement de l'anneau brillant au sein de la seconde image ; et
déterminer la seconde erreur en comparant l'emplacement de l'anneau brillant au premier point d'échantillonnage du modèle.

**7.** Procédé de mesure tridimensionnelle d'un cristal en croissance étant tiré à partir d'un creuset, dans lequel un premier appareil photo (80) capture une première image du cristal en croissance sur un premier plan d'image et un second appareil photo (82) capture une seconde image du cristal en croissance sur un deuxième plan d'image, le procédé comprenant les étapes consistant à :

générer un modèle mathématique d'un cristal pendant la croissance du cristal, le modèle mathématique comprenant une pluralité de points d'échantillonnage de modèle;
détecter au moins une caractéristique de croissance des cristaux au sein de la première image et de la seconde image ;
déterminer une première valeur d'erreur en comparant le modèle mathématique à la caractéristique de croissance des cristaux dans la première image et une seconde valeur d'erreur en comparant le modèle mathématique à la caractéristique de croissance des cristaux dans la seconde image ; et
générer à partir du modèle mathématique, et sur la base de la première valeur d'erreur déterminée et de la seconde valeur d'erreur déterminée, une valeur estimée de métrologie associée à la au moins une caractéristique de croissance des cristaux.

**8.** Procédé selon la revendication 7, dans lequel la détermination de la première valeur d'erreur et de la deuxième valeur d'erreur comprend la détermination d'une pluralité de points normaux de caractéristique pour au moins l'un de la pluralité de points d'échantillonnage du modèle, la pluralité de points normaux de caractéristique définissent une ligne d'échantillonnage qui comprend la pluralité de points normaux de caractéristique et le au moins un de la pluralité de points d'échantillonnage du modèle,
dans lequel la ligne d'échantillonnage est orthogonale à une tangente d'une surface du modèle mathématique et à un chemin d'accès à un centre de l'objectif de l'appareil photo d'au moins l'un du premier appareil photo et du second appareil photo depuis le point d'échantillonnage du modèle.

9. Procédé selon la revendication 8, dans lequel la détermination de la première valeur d'erreur et de la seconde valeur d'erreur comporte les étapes consistant à :

projeter la ligne d'échantillonnage sur le premier plan d'image ;
effectuer un échantillonnage le long de la ligne d'échantillonnage afin de déterminer un emplacement d'un anneau brillant dans le premier plan d'image image ; déterminer la première valeur d'erreur en comparant l'emplacement de l'anneau brillant à au moins l'un de la pluralité de points d'échantillonnage du modèle ;
projeter la ligne d'échantillonnage sur le second plan image ;
effectuer un échantillonnage le long de la ligne d'échantillonnage afin de déterminer un emplacement de l'anneau brillant sur le second plan d'image ; et
déterminer la seconde valeur d'erreur en comparant l'emplacement de l'anneau brillant à au moins l'un de la pluralité de points d'échantillonnage du modèle.

10. Procédé selon l'une quelconque des revendications 7 à 9, dans lequel la génération d'une valeur de métrologie estimée comporte de déterminer que la première valeur d'erreur et la seconde valeur sont égales ou inférieures à un niveau d'erreur prédéfini.

11. Procédé selon l'une quelconque des revendications 7 à 9, comportant en outre les étapes consistant à :

déterminer que la première valeur d'erreur et la seconde valeur d'erreur sont supérieures à un niveau d'erreur prédéfini ; et
générer des valeurs d'ajustement de modèle mathématique en appliquant une matrice de gain à la première valeur d'erreur et à la seconde valeur d'erreur, générer un modèle mathématique ajusté en ajustant le modèle mathématique conformément à des valeurs d'ajustement de modèle mathématique, le modèle mathématique ajusté comportant une pluralité de points d'échantillonnage de modèle ajusté ;
déterminer une pluralité de points normaux de caractéristique pour au moins un de la pluralité de points d'échantillonnage du modèle ajusté, la pluralité de points normaux de caractéristique et le au moins un de la pluralité de points d'échantillonnage du modèle ajusté définissant une ligne d'échantillonnage ajustée ;
projeter la ligne d'échantillonnage ajustée sur le premier plan d'image ;
effectuer un échantillonnage le long de la ligne d'échantillonnage afin de déterminer un emplacement d'un anneau brillant sur le premier plan de l'image ;
déterminer la première valeur d'erreur en comparant l'emplacement de l'anneau brillant à le au moins un de la pluralité de points d'échantillonnage du modèle ajusté ;
projeter la ligne d'échantillonnage ajustée sur le second plan image ;
effectuer un échantillonnage le long de la ligne d'échantillonnage ajustée afin de déterminer un emplacement de l'anneau brillant sur le deuxième plan d'image ;
déterminer la seconde valeur d'erreur en comparant l'emplacement de l'anneau brillant à le au moins un de la pluralité de points d'échantillonnage du modèle ajusté ;
déterminer que la première valeur d'erreur et la seconde valeur d'erreur sont inférieures ou égales à un niveau d'erreur prédéfini; et
générer une valeur de métrologie estimée ajustée de la au moins une caractéristique de croissance cristalline sur la base de la pluralité de points d'échantillonnage du modèle ajusté.

12. Procédé selon l'une quelconque des revendications 7 à 11, comprenant en outre la génération d'une référence de modèle mathématique supposé sur laquelle le modèle mathématique est centré.

13. Procédé selon l'une quelconque des revendications 7 à 12, dans lequel la pluralité de points du modèle mathématique représente au moins une caractéristique d'un cristal, dans lequel la au moins une caractéristique comprend au moins l'un d'un diamètre de cristal, d'une élévation de la fusion, et d'une élévation du réflecteur.

14. Procédé selon l'une quelconque des revendications 7 à 13, comprenant en outre d'étalonner le premier appareil photo et le second appareil photo, dans lequel l'étalonnage comprend la génération d'un ensemble de données de paramètres d'étalonnage servant à déterminer la pluralité de points normaux de caractéristique pour au moins l'un de la pluralité de points d'échantillonnage du modèle.

15. Procédé selon l'une quelconque des revendications 7 à 14, dans lequel la génération d'un modèle mathématique d'un cristal pendant la croissance des cristaux comprend la génération d'une pluralité de points ayant chacun des coordonnées tridimensionnelles.

16. Procédé selon l'une quelconque des revendications 7 à 15, dans lequel la génération d'une valeur de métrologie d'au moins l'une des caractéristiques de cristal comprend la génération d'au moins l'un d'un diamètre estimé de cristal, d'une élévation de fusion estimée, et d'une longueur estimée de l'écart fusion - réflecteur.

FIG. 1

EP 2 659 031 B1

FIG. 2

FIG. 3

FIG. 4

EP 2 659 031 B1

FIG. 5

EP 2 659 031 B1

FIG. 6

28

FIG. 7

FIG. 8

GENERATING A MATHEMATICAL MODEL — 260

DETECTING A CRYSTAL GROWTH FEATURE WITHIN A FIRST IMAGE AND A SECOND IMAGE — 264

DETERMINING A FIRST ERROR VALUE — 266

DETERMINING A SECOND ERROR VALUE — 268

BASED ON THE DETERMINED FIRST ERROR VALUE AND THE DETERMINED SECOND ERROR VALUE, GENERATING, FROM THE MATHEMATICAL MODEL, AN ESTIMATED 3-D WORLD METROLOGY VALUE ASSOCIATED WITH THE CRYSTAL GROWTH FEATURE — 270

FIG. 9

DETERMINING A FIRST PLURALITY OF FEATURE NORMAL POINTS — 310

PROJECTING A SAMPLING LINE ONTO A FIRST IMAGE PLANE — 312

SAMPLING ALONG THE SAMPLING LINE TO DETERMINE A LOCATION OF A BRIGHT RING WITHIN THE FIRST IMAGE — 314

COMPARING THE LOCATION OF THE BRIGHT RING TO THE LOCATION OF THE MODEL SAMPLE POINT TO DETERMINE THE FIRST ERROR — 316

DETERMINING A SECOND PLURALITY OF FEATURE NORMAL POINTS — 320

PROJECTING A SAMPLING LINE ONTO A SECOND IMAGE PLANE — 322

SAMPLING ALONG THE SAMPLING LINE TO DETERMINE A LOCATION OF THE BRIGHT RING WITHIN THE SECOND IMAGE — 324

COMPARING THE LOCATION OF THE BRIGHT RING TO THE LOCATION OF THE MODEL SAMPLE POINT TO DETERMINE THE SECOND ERROR — 326

— 300
— 266
— 268

FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

• DE 19738438

### Non-patent literature cited in the description

• **KIMBEL et al.** Shape estimation for on-line diameter calibration in Czochralski silicon crystal growth. *Proc. SPIE,* 2001, vol. 4188, 4556
• **HEIKKILÄ ; SILVÉN.** A Four-step Camera Calibration Procedure with Implicit Image Correction. *IEEE Computer Society Conference on Computer Vision and Pattern Recognition,* vol. 12997, 1006-1112
• **R.Y. TSAI.** A Versatile Camera Calibration Technique for High-Accuracy 3-D Machine Vision Metrology Using Off-the-Shelf TV Cameras and Lenses. *IEEE Journal of Robotics and Automation,* August 1987, vol. RA-3 (4), 323-344
• **CZOCHRALSKI ; GROWTH.** *Journal of Crystal Growth,* 1983, vol. 63, 13-17
• **A. BLAKE ; M. ISARD.** Active Contours. Springer-Verlag, 1998